# EUROPEAN PATENT SPECIFICATION

(11) **EP 3 709 373 B1**
(45) Date of publication and mention of the grant of the patent: **09.11.2022**
(21) Application number: 19386013.7
(22) Date of filing: 15.03.2019
(51) Int. Cl.: H01L 31/032, H01L 51/46, G01D 5/00

(54) **DOUBLE PEROVSKITE**
DOPPELPEROWSKIT
PÉROVSKITE DOUBLE

(43) Date of publication of application: 16.09.2020
(73) Proprietor: Oxford University Innovation Limited, Oxford OX2 0JB (GB)
(72) Inventor: Volonakis, Yorgos, Oxford, OX1 3PH (GB); Giustino, Feliciano, Oxford, OX1 3PH (GB); Snaith, Henry James, Oxford, OX1 3PU (GB); Sakai, Nobuya, Oxford, OX1 3PU (GB)
(74) Representative: J A Kemp LLP

(56) References cited:
- CN-A- 102 634 340
- SARIFUL SHEIKH MD ET AL: "Lead free double perovskite oxides Ln2NiMnO6(Ln=La, Eu, Dy, Lu), a new promising material for photovoltaic application", MATERIALS SCIENCE AND ENGINEERING: B, vol. 226, 31 August 2017 (2017-08-31), pages 10-17, XP085259040, ISSN: 0921-5107, DOI: 10.1016/J.MSEB.2017.08.027
- FRANK KUBEL, NICOLE WANDL, MARIANA PANTAZI, VINCENZA D'ANNA, ANDHANS HAGEMANN: "The Periodate-Based Double Perovskites M2NaIO6 (M = Ca, Sr, and Ba)", Z. ANORG. ALLG. CHEM., vol. 639, no. 6, 18 April 2013 (2013-04-18), pages 892-898, XP002793605, DOI: 10.1002/zaac.201200555
- HATAKEYAMA TAKUYA ET AL: "Photocatalytic activities of Ba2RBiO6 (R= La, Ce, Nd, Sm, Eu, Gd, Dy) under visible light irradiation", JOURNAL OF THE CERAMIC SOCIETY OF JAPAN, vol. 118, no. 2, 1 January 2010 (2010-01-01), pages 91-95, XP055818639, DOI: doi:10.2109/jcersj2.118.91
- SHU-TING PI ET AL: "Design a giant-gap 3D topological insulator: The case of double perovskites", ARXIV.ORG, CORNELL UNIVERSITY LIBRARY, 201 OLIN LIBRARY CORNELL UNIVERSITY ITHACA, NY 14853, 29 September 2016 (2016-09-29), XP080814360,

## Description

### FIELD OF THE INVENTION

The invention relates to a compound, and to an optoelectronic material, a photocatalyst material, a semiconductor device and an electronic material, comprising the compound. The invention also relates to a process for preparing the compound.

### BACKGROUND TO THE INVENTION

Perovskites are one of the most common crystals, and have been employed for a broad range of applications such as transistors, solar-cells, light-emitting devices, memories, catalysts, and superconductors. Within the perovskite family, halide perovskites have attracted tremendous scientific and technological interest over the last few years, and revolutionized the field of emerging photovoltaics. Solar cells based on lead-halide perovskites have recently achieved record-breaking power conversion efficiencies of more than 23%, surpassing state-of-the-art copper-indium-gallium-selenide (CIGS) and thin-film silicon technologies (see Best Research-Cell Efficiencies. http://www.nrel.gov/). Moreover, the initial concerns over the stability of halide perovskite devices have been alleviated, with devices reaching stabilized efficiencies of more than 20% (see Turren-Cruz, S.-H.; Hagfeldt, A.; Saliba, M. Science 2018, 362, 449-453). Despite this enormous progress, it would be desirable to replace Pb with an environmental friendly, less toxic element. To this aim, halide double perovskites have recently been designed and synthesized as potential lead-free alternatives (Volonakis, G.; Filip, M. R.; Haghighirad, A. A.; Sakai, N.; Wenger, B.; Snaith, H. J.; Giustino, F. J. Phys. Chem. Lett. 2016, 7, 1254-1259; Slavney, A. H.; Hu, T.; Lindenberg, A. M.; Karunadasa, H. I. J. Am. Chem. Soc. 2016, 138, 2138-2141; McClure, E. T.; Ball, M. R.; Windl, W.; Woodward, P. M. Chem. Mater. 2016, 28, 1348-1354; Volonakis, G.; Haghighirad, A. A.; Milot, R. L.; Sio, W. H.; Filip, M. R.; Wenger, B.; Johnston, M. B.; Herz, L. M.; Snaith, H. J.; Giustino, F. J. Phys. Chem. Lett. 2017, 8, 772-778). Among the synthesized double perovskites, Cs₂BiAgBr₆ has the lowest band gap of 1.9 eV (Slavney, A. H.; Hu, T.; Lindenberg, A. M.; Karunadasa, H. I. J. Am. Chem. Soc. 2016, 138, 2138-2141; McClure, E. T.; Ball, M. R.; Windl, W.; Woodward, P. M. Chem. Mater. 2016, 28, 1348-1354; Filip, M. R.; Hillman, S.; Haghighirad, A. A.; Snaith, H. J.; Giustino, F. J. Phys. Chem. Lett. 2016, 7, 2579-2585). However, this band gap is indirect. Cs₂AgInCl₆ is the only direct gap semiconductor, but the band gap is relatively large, 3.3 eV (Volonakis, G.; Haghighirad, A. A.; Milot, R. L.; Sio, W. H.; Filip, M. R.; Wenger, B.; Johnston, M. B.; Herz, L. M.; Snaith, H. J.; Giustino, F. J. Phys. Chem. Lett. 2017, 8, 772-778; Locardi, F.; Cirignano, M.; Baranov, D.; Dang, Z.; Prato, M.; Drago, F.; Ferretti, M.; Pinchetti, V.; Fanciulli, M.; Brovelli, S.; De Trizio, L.; Manna, L. J. Am. Chem. Soc. 2018, 140, 12989-12995; Luo, J.; Li, S.; Wu, H.; Zhou, Y.; Li, Y.; Liu, J.; Li, J.; Li, K.; Yi, F.; Niu, G.; Tang, J. ACS Photonics 2018, 5, 398-405). There therefore exists a need to identify lead-free perovskites with direct band gaps which are low (less than 3 eV) for applications in optoelectronics, for instance as photovoltaic materials or as electroluminescent materials; as semiconductors; as electronic materials which may be used to conduct charge, for instance in transistors; and as photoluminescent materials.

Based on a rational design strategy, recently it has been shown that in order to match the remarkable optoelectronic properties of lead-based compounds, non-toxic halide double perovskites must combine indium (In) as a monovalent cation and Sb or Bi as the trivalent cation (see Volonakis, G.; Haghighirad, A. A.; Snaith, H. J.; Giustino, F. J. Phys. Chem. Lett. 2017, 8, 3917-3924). However, these compounds have not been synthesized yet.

Historically, oxide ABO₃ perovskites and A₂BB'O₆ double perovskites have been investigated for over a century, well before the emergence of halide perovskites. Cuprates for example have been a prototypical system for high-temperature superconductors for decades (Bednorz, J. G.; Muller, K. A. Z. Phys. B 1986, 64, 189-193), while manganese-based oxide perovskites are the most prominent materials to exhibit colossal magnetoresistance (Jin, S.; Tiefel, T. H.; McCormack, M.; Fastnacht, R. A.; Ramesh, R.; Chen, L. H. Science 1994, 264, 413-415). Overall, the vast majority of existing perovskites (68%) are oxides (Luo, X.; Oh, Y. S.; Sirenko, A.; Gao, P.; Tyson, T. A.; Char, K.; Cheong, S.-W. Appl. Phys. Lett. 2012, 100, 172112; Kim, H. J.; Kim, U.; Kim, H. M.; Kim, T. H.; Mun, H. S.; Jeon, B.-G.; Hong, K. T.; Lee, W.-J.; Ju, C.; Kim, K. H.; Char, K. Appl. Phys. Express 2012, 5, 061102; Shin, S. S.; Yeom, E. J.; Yang, W. S.; Hur, S.; Kim, M. G.; Im, J.; Seo, J.; Noh, J. H.; Seok, S. I. Science 2017, 356, 167-171), while halides account only for 16% of known compounds (see Filip, M. R.; Giustino, F. Proc. Natl. Acad. Sci. 2018, 115, 5397-5402; Volonakis, G.; Filip, M. R.; Haghighirad, A. A.; Sakai, N.; Wenger, B.; Snaith, H. J.; Giustino, F. J. Phys. Chem. Lett. 2016, 7, 1254-1259; Volonakis, G.; Haghighirad, A. A.; Milot, R. L.; Sio, W. H.; Filip, M. R.; Wenger, B.; Johnston, M. B.; Herz, L. M.; Snaith, H. J.; Giustino, F. J. Phys. Chem. Lett. 2017, 8, 772-778; Volonakis, G.; Haghighirad, A. A.; Snaith, H. J.; Giustino, F. J. Phys. Chem. Lett. 2017, 8, 3917-3924).

Nechache et al. (Nechache et al., Bandgap tuning of multiferrooic oxide solar cells, Nature Photonics, 2014, pages 61 to 67) discloses multiferroic oxide solar cells. Sleight et al. (Sleight et al., Compounds of Post-Transition Elements with the Ordered Perovskite Structure, 1963, Inorganic Chemistry p292) describes the synthesis of a number of double perovskite compounds. De Hair et al. (De Hair et al., Vibrational Spectra and Force Constants of Periodates with Ordered Perovskite Structure, J. inorg. Nucl. Chem, 1974, vol. 36, pp 313-315) describes the vibrational spectra of a number of double perovskite compounds.

Kubel et al. (Kubel, et al., The Periodate-Based Double Perovskites M2NaIO6 (M = Ca, Sr, and Ba), Z. Anorg. Allg. Chem 2013, 639, pages 892-898) discloses the crystal structures of the M₂NaIO₆ series (M = Ca, Sr, Ba), prepared at 650 °C by ceramic methods.

### SUMMARY OF THE INVENTION

The present invention provides compounds which are useful as semiconducting materials and/or photoactive (e.g. optoelectronic) materials and which do not have the disadvantages associated with the prior art. In particular, the invention provides compounds that (i) have a direct band gap, (ii) have a band gap of a suitable size for optoelectronic applications, (iii) are made from easily available, environmentally friendly, non-toxic materials and (iv) can be synthesised via a straight-forward low temperature route, for instance by solution processing, from readily available starting materials. The inventors have in particular developed a new family of compounds that have utility as optoelectronic, photoluminescent, photocatalytic and semiconducting materials. Following the recent discovery that Cs₂AgInCl₆ is an efficient light-emissive material, the inventors explored the relationship between that compound and other double perovskites such as chalcogen double perovskites. The link between chalcogen and halide perovskites was found to be in the electronic valency of the cations at the B sites. The optical absorption and photoluminescence of the double perovskites investigated are described. The inventors surprisingly found that chalcogen analogs of Cs₂AgInCl₆ have a significantly lower band gap than Cs₂AgInCl₆. The band gap of Ba₂AgIO₆ for instance is shown to be 1.9eV, well into the visible region, indicating that the chalcogen analog materials of the invention are highly promising as optoelectronic materials. Chalcogen double perovskites including Ba₂AgIO₆ have therefore been identified as compounds having a band gap in the visible, and a band structure similar to that of Cs₂AgInCl₆, and therefore have utility in a wide variety of applications including optoelectronic, photoluminescent, photocatalytic and semiconducting materials. This new class of materials also allows the use of lead (and other toxic heavy metals) to be avoided completely, providing a significant environmental benefit. The materials have a strong potential for optimizing lead-free perovskite photovoltaics. The novel double perovskites are also stable with respect to oxidation.

The invention therefore provides an optoelectronic material comprising a compound, wherein the compound comprises:
(i) one or more cations, A;
(ii) one or more first B cations, Bⁿ⁺, at least one of which is Ag⁺;
(iii) one or more second B cations, B^{m+}, at least one of which is a heptacation, B⁷; and
(iv) one or more chalcogen anions, X;
wherein the one or more first B cations, Bⁿ⁺ are different from the one or more second B cations, B^{m+}; n represents the oxidation state of the first B cation and is a positive integer of from 1 to 7 inclusive; m represents the oxidation state of the second B cation and is a positive integer of from 1 to 7 inclusive; and n + m is equal to 8.

The invention also provides a compound comprising:
(i) One or more cations, A;
(ii) One or more monocations, B⁺, wherein one of said one or more monocations is Ag⁺;
(iii) One or more heptacations, B⁷⁺; and
(iv) One or more chalcogen anions, X.

The invention also provides a photocatalyst material comprising a compound, wherein the compound comprises:
(i) one or more cations, A;
(ii) one or more first B cations, Bⁿ⁺, at least one of which is Ag⁺;
(iii) one or more second B cations, B^{m+}, at least one of which is a heptacation, B⁷⁺; and
(iv) one or more chalcogen anions, X;
wherein the one or more first B cations, Bⁿ⁺ are different from the one or more second B cations, B^{m+}; n represents the oxidation state of the first B cation and is 1 or 2; m represents the oxidation state of the second B cation and is 6 or 7; and n + m is equal to 8.

The invention also provides a semiconductor device comprising a semiconducting material, wherein the semiconducting material comprises a compound comprising:
(i) one or more cations, A;
(ii) one or more first B cations, Bⁿ⁺, at least one of which is Ag⁺;
(iii) one or more second B cations, B^{m+}, at least one of which is a heptacation, B⁷⁺; and
(iv) one or more chalcogen anions, X;
wherein the one or more first B cations, Bⁿ⁺ are different from the one or more second B cations, B^{m+}; n represents the oxidation state of the first B cation and is a positive integer of from 1 to 7 inclusive; m represents the oxidation state of the second B cation and is a positive integer of from 1 to 7 inclusive; and n + m = 8.

### The invention also provides an electronic material comprising a compound as defined herein

The inventors also developed a successful synthesis pathway to the compounds defined herein (i.e. to chalcogen analog materials including Ba₂AgIO₆) through a newly developed low-temperature solution processing route. The inventors have found that it is critical to synthesize the precursor compound first, prior to treating the precursor compound with the composition the one or more cations, A. The inventors have found that the methods described in the prior art, in which solutions comprising all the B and A cations are simply mixed do not yield the desired compound. Instead, a compound comprising the B and X ions only, for instance a compound according to Formula V below, is typically formed rather than the desired product. The inventors have surprisingly found that the process in which this precursor compound is formed first, then treated with the one or more cations, A, provides the desired compound as the product.

The invention therefore provides a process for producing a compound comprising
(i) one or more cations, A;
(ii) one or more first B cations, Bⁿ⁺, at least one of which is Ag⁺;
(iii) one or more second B cations, B^{m+}, at least one of which is a heptacation, B⁷⁺; and
(iv) one or more chalcogen anions, X;

wherein the one or more first B cations, Bⁿ⁺ are different from the one or more second B cations, B^{m+}; n represents the oxidation state of the first B cation and is a positive integer of from 1 to 7 inclusive; m represents the oxidation state of the second B cation and is a positive integer of from 1 to 7 inclusive; and n + m = 8;
said process comprising treating a precursor compound comprising the one or more first B cations, Bⁿ⁺, and the one or more second B cations, B^{m+}, with a composition comprising the one or more cations, A to obtain the compound,
wherein the precursor compound is a solid, which process comprises dissolving the solid precursor compound comprising the one or more first B cations, Bⁿ⁺ , and the one or more second B cations, B^{m+}, in a solvent to obtain a solution comprising the one or more first B cations Bⁿ⁺ , and the one or more second B cations, B^{m+}, and contacting the solution with the composition comprising the one or more cations, A, to obtain the compound.

### BRIEF DESCRIPTION OF THE FIGURES

Figure 1(a) shows an atomistic illustration of the crystal structure of Ba₂BIO₆ oxide double perovskites with B = Na, Ag. Figure 1(b) shows the DFT-PBEO electronic band structure of Ba₂NaIO₆, Ba₂AgIO₆ and Cs₂AgInCl₆. Effective masses are shown in light grey. The energy axis is referred to the valence band top.
Figure 2 shows the DFT-PBEO electronic band structure of Ba₂AgIO₆ showing the contribution of Ag 4d-orbitals (left panel) and O 2p-orbitals (right panel).
Figure 3 (a) is a schematic illustration of the family of analogs including oxides (left), halides (right), single (top) and double (bottom) perovskites. The focus is on compounds where the B site cations have d¹⁰s⁰ valency. Figure 3(b) shows the DFT-PBEO electronic band structures of single perovskite BaSnO₃, its halide analog CsCdCl₃, and (c) its double perovskite analogs Ba₂InSbO₆ and Ba₂CdTeO₆. The band folding effect for BaSnO₃ with a supercell corresponding to the Fm3m lattice is also shown.
Figure 4(a) shows all-electron energy levels of the 4d-orbitals of Ag, Cd, In, Sn, Sb, Te and I, compared to the energy level of the O 2p orbital. Figure 4(b) shows the square modulus of the electron wavefunction at the valence band top, for Ba₂CdTeO₆ and Ba₂AgIO₆ oxide double perovskites
Figure 5 shows X-ray diffraction pattern for the synthesized AgIO₄. Solid line is the pattern of the reference AgIO₄ compound reported in the inorganic crystal structure database (#52380). Inset shows image of the synthesized AgIO₄ yellow powder.
Figure 6(a) shows X-ray diffraction pattern of the as-synthesized Ba₂AgIO₆ (points), and simulated pattern of the DFT-PBE optimized structure (solid line). The inset is a photograph of the as-synthesized powder. The arrows indicate peaks that are tentatively assigned to AgI impurities. Figure 6(b) shows the UV-Vis absorption and photoluminescence spectra for Ba₂AgIO₆. The inset shows the corresponding Tauc plot. Figure 6(c) shows the time-resolved photoluminescence decay of Ba₂AgIO₆ and corresponding bi-exponential fit.
Figure 7 shows the powder X-ray diffraction spectrum of the product from the comparative synthesis example described below.

### DETAILED DESCRIPTION OF THE INVENTION

### Definitions

The term "optoelectronic material", as used herein, refers to a material which either (i) absorbs light, which may then generate free charge carriers; or (ii) accepts charge, both electrons and holes, which may subsequently recombine and emit light. Such materials may also be referred to as "photoactive materials". Optoelectronic/photoactive materials may be examples of semiconducting materials.

The term "photovoltaic material", as used herein, refers to a material that absorbs light, then generates free charge carriers.

The term "electroluminescent material", as used herein, refers to a material that accepts charge, both electrons and holes, which subsequently recombine and emit light.

The term "photoluminescent material", as used herein, refers to a material that is able to absorb photons and undergo photoexcitation, then emit photons. A photoemissive material is a material which absorbs light of energies higher than band gap and reemits light at energies at the band gap.

The term "electronic material", as used herein, refers to a material that is able to conduct charge. An electronic material may be a hole conductor material, an electron transporting material, or a material capable of transporting electrons and holes. An electronic material is typically suitable for use in a transistor.

The terms "semiconductor" and "semiconducting material", as used herein, both refer to a material with electrical conductivity intermediate in magnitude between that of a conductor and a dielectric. A semiconductor or semiconducting material may be an negative (n)-type semiconductor, a positive (p)-type semiconductor or an intrinsic (i) semiconductor. A semiconductor or semiconducting material may have a band gap of from 0.5 to 3.5 eV, for instance from 0.5 to 2.5 eV or from 1.0 to 2.0 eV (when measured at 300 K). The terms "semiconductor" and "semiconducting material" have the same meaning herein and may be used interchangeably. The compounds defined herein are typically semiconductors.

The terms "semiconductor device" and "semiconducting device", as used herein, refer to a device comprising a functional component which comprises a semiconducting material. Examples of semiconductor devices include a photovoltaic device, a solar cell, a photo detector, a photodiode, a photosensor, a chromogenic device, a transistor, a light-sensitive transistor, a phototransistor, a solid state triode, a battery, a battery electrode, a capacitor, a super-capacitor, a light-emitting device and a light-emitting diode. The terms "semiconductor device" and "semiconducting device" have the same meaning herein and may be used interchangeably.

The term "optoelectronic device", as used herein, refers to devices which source, control, detect or emit light. Light is understood to include any electromagnetic radiation. Examples of optoelectronic devices include photovoltaic devices, photodiodes (including solar cells), phototransistors, photomultipliers, photoresistors, light emitting devices, electroluminescent devices, light emitting diodes and charge injection lasers. Often, an "optoelectronic device" that is referred to herein is a photovoltaic device or an electroluminescent device.

The term "crystalline" as used herein indicates a crystalline compound, which is a compound having an extended 3D crystal structure. A crystalline compound is typically in the form of crystals or, in the case of a polycrystalline compound, crystallites (i.e. a plurality of crystals having particle sizes of less than or equal to 1 µm). The crystals together often form a layer. The crystals of a crystalline material may be of any size. Where the crystals have one or more dimensions in the range of from 1 nm up to 1000 nm, they may be described as nanocrystals. The compounds defined herein are generally crystalline compounds. They are typically crystalline semiconductors.

The term "monocation", as used herein, refers to any cation with a single positive charge, i.e. a cation of formula A⁺ where A is any chemical moiety, for instance a metal atom or an organic moiety. The term "dication", as used herein, refers to any cation with a double positive charge, i.e. a cation of formula A²⁺ where A is any chemical moiety, for instance a metal atom or organic moiety. The term "trication", as used herein, refers to any cation with a triple positive charge, i.e. a cation of formula A³⁺ where A is any chemical moiety, for instance a metal atom. The term "tetracation", as used herein, refers to any cation with a quadruple positive charge, i.e. a cation of formula A⁴⁺ where A is any chemical moiety, for instance a metal atom. The term "heptacation", as used herein, refers to any cation with a +7 charge, i.e. a cation of A⁷⁺ where A is any chemical moiety, for instance a metal atom or a halogen atom.

The term "n-type region", as used herein, refers to a region of one or more electron-transporting (i.e. n-type) materials. Similarly, the term "n-type layer" refers to a layer of an electron-transporting (i.e. an n-type) material. An electron-transporting (i.e. an n-type) material could, for instance, be a single electron-transporting compound or elemental material. An electron-transporting compound or elemental material may be undoped or doped with one or more dopant elements.

The term "p-type region", as used herein, refers to a region of one or more hole-transporting (i.e. p-type) materials. Similarly, the term "p-type layer" refers to a layer of a hole-transporting (i.e. a p-type) material. A hole-transporting (i.e. a p-type) material could be a single hole-transporting compound or elemental material, or a mixture of two or more hole-transporting compounds or elemental materials. A hole-transporting compound or elemental material may be undoped or doped with one or more dopant elements.

The term "perovskite", as used herein, refers to a material with a three-dimensional crystal structure related to that of CaTiO₃ or a material comprising a layer of material, which layer has a structure related to that of CaTiO₃. The structure of CaTiO₃ can be represented by the formula ABX₃, wherein A and B are cations of different sizes and X is an anion. In the unit cell, the A cations are at (0,0,0), the B cations are at (1/2, 1/2, 1/2) and the X anions are at (1/2, 1/2, 0). The A cation is usually larger than the B cation. The skilled person will appreciate that when A, B and X are varied, the different ion sizes may cause the structure of the perovskite material to distort away from the structure adopted by CaTiO₃ to a lower-symmetry distorted structure. The symmetry will also be lower if the material comprises a layer that has a structure related to that of CaTiO₃. Materials comprising a layer of perovskite material are well known. For instance, the structure of materials adopting the K₂NiF₄-type structure comprises a layer of perovskite material. The skilled person will appreciate that a perovskite material can be represented by the formula [A][B][X]₃, wherein [A] is at least one cation, [B] is at least one cation and [X] is at least one anion. When the perovskite comprise more than one A cation, the different A cations may distributed over the A sites in an ordered or disordered way. When the perovskite comprises more than one B cation, the different B cations may distributed over the B sites in an ordered or disordered way. When the perovskite comprise more than one X anion, the different X anions may distributed over the X sites in an ordered or disordered way. The symmetry of a perovskite comprising more than one A cation, more than one B cation or more than one X cation, will be lower than that of CaTiO₃. For layered perovskites the stoichiometry can change between the A, B and X ions. As an example, the [A]₂[B][X]₄ structure can be adopted if the A cation has a too large an ionic radii to fit within the 3D perovskite structure. The term "perovskite" also includes A/M/X materials adopting a Ruddleson-Popper phase. Ruddleson-Popper phase refers to a perovskite with a mixture of layered and 3D components. Such perovskites can adopt the crystal structure, Aₙ₋₁A'₂MₙX₃ₙ₊₁, where A and A' are different cations and n is an integer from 1 to 8, or from 2 to 6. The term "perovskite" also includes A/M/X materials adopting a Dion-Jacobson phase. Dion-Jacobson phase refers to a perovskite with a mixture of layered and 3D components. Such perovskites can adopt the crystal structure, A_{q-1}A'B_{q}X_{3q+1}, where A and A' are different cations and q is an integer from 1 to 8, or from 2 to 6. The term "mixed 2D and 3D" perovskite is used to refer to a perovskite film within which there exists both regions, or domains, of AMX₃ and Aₙ₋₁A'₂MₙX₃ₙ₊₁ perovskite phases.

The term "halide" as used herein indicates the singly charged anion of an element in group VII of the periodic table. "Halide" includes fluoride, chloride, bromide and iodide.

The term "alkyl", as used herein, refers to a linear or branched chain saturated hydrocarbon radical. An alkyl group may be a C₁₋₂₀ alkyl group, a C₁₋₁₄ alkyl group, a C₁₋₁₀ alkyl group, a C₁₋₆ alkyl group or a C₁₋₄ alkyl group. Examples of a C₁₋₁₀ alkyl group are methyl, ethyl, propyl, butyl, pentyl, hexyl, heptyl, octyl, nonyl or decyl. Examples of C₁₋₆ alkyl groups are methyl, ethyl, propyl, butyl, pentyl or hexyl. Examples of C₁₋₄ alkyl groups are methyl, ethyl, i-propyl, n-propyl, t-butyl, s-butyl or n-butyl. If the term "alkyl" is used without a prefix specifying the number of carbons, it typically has from 1 to 6 carbons (and this also applies to any other organic group referred to herein).

The term "cycloalkyl", as used herein, refers to a saturated or partially unsaturated cyclic hydrocarbon radical. A cycloalkyl group may be a C₃₋₁₀ cycloalkyl group, a C₃₋₈ cycloalkyl group or a C₃₋₆ cycloalkyl group. Examples of a C₃₋₈ cycloalkyl group include cyclopropyl, cyclobutyl, cyclopentyl, cyclohexyl, cyclohexenyl, cyclohex-1,3-dienyl, cycloheptyl and cyclooctyl. Examples of a C₃₋₆ cycloalkyl group include cyclopropyl, cyclobutyl, cyclopentyl, and cyclohexyl.

The term "aryl", as used herein, refers to a monocyclic, bicyclic or polycyclic aromatic ring which contains from 6 to 14 carbon atoms, typically from 6 to 10 carbon atoms, in the ring portion. Examples include phenyl, naphthyl, indenyl, indanyl, anthrecenyl and pyrenyl groups. The term "aryl group", as used herein, includes heteroaryl groups. The term "heteroaryl", as used herein, refers to monocyclic or bicyclic heteroaromatic rings which typically contains from six to ten atoms in the ring portion including one or more heteroatoms. A heteroaryl group is generally a 5- or 6-membered ring, containing at least one heteroatom selected from O, S, N, P, Se and Si. It may contain, for example, one, two or three heteroatoms. Examples of heteroaryl groups include pyridyl, pyrazinyl, pyrimidinyl, pyridazinyl, furanyl, thienyl, pyrazolidinyl, pyrrolyl, oxazolyl, oxadiazolyl, isoxazolyl, thiadiazolyl, thiazolyl, isothiazolyl, imidazolyl, pyrazolyl, quinolyl and isoquinolyl.

The term "alkylene group" as used herein, refers to a substituted or unsubstituted bidentate moiety obtained by removing two hydrogen atoms, either both from the same carbon atom, or one from each of two different carbon atoms, of a hydrocarbon compound having from 1 to 20 carbon atoms (unless otherwise specified), which may be aliphatic or alicyclic, and which may be saturated, partially unsaturated, or fully unsaturated. Thus, the term "alkylene" includes the sub-classes alkenylene, alkynylene, cycloalkylene, etc., discussed below. Typically it is C₁₋₁₀ alkylene, for instance C₁₋₆ alkylene. Typically it is C₁₋₄ alkylene, for example methylene, ethylene, i-propylene, n-propylene, t-butylene, s-butylene or n-butylene. It may also be pentylene, hexylene, heptylene, octylene and the various branched chain isomers thereof. An alkylene group may be substituted or unsubstituted, for instance, as specified above for alkyl. Typically a substituted alkylene group carries 1, 2 or 3 substituents, for instance 1 or 2.

In this context, the prefixes (e.g., C₁₋₄, C₁₋₇, C₁₋₂₀, C₂₋₇, C₃₋₇, etc.) denote the number of carbon atoms, or range of number of carbon atoms. For example, the term "C₁₋₄alkylene," as used herein, pertains to an alkylene group having from 1 to 4 carbon atoms. Examples of groups of alkylene groups include C₁₋₄ alkylene ("lower alkylene"), C₁₋₇ alkylene, C₁₋₁₀ alkylene and C₁₋₂₀ alkylene.

Examples of linear saturated C₁₋₇ alkylene groups include, but are not limited to, -(CH₂)ₙ-where n is an integer from 1 to 7, for example, -CH₂- (methylene), -CH₂CH₂-(ethylene), -CH₂CH₂CH₂- (propylene), and -CH₂CH₂CH₂CH₂- (butylene). Examples of branched saturated C₁₋₇ alkylene groups include, but are not limited to, -CH(CH₃)-, -CH(CH₃)CH₂-, -CH(CH₃)CH₂CH₂-, -CH(CH₃)CH₂CH₂CH₂-, -CH₂CH(CH₃) CH₂-, -CH₂CH(CH₃)CH₂CH₂-, -CH(CH₂CH₃)-, -CH(CH₂CH₃)CH₂-, and -CH₂CH(CH₂CH₃)CH₂-.

Examples of linear partially unsaturated C₁₋₇ alkylene groups include, but are not limited to, - CH=CH- (vinylene), -CH=CH-CH₂-, -CH₂-CH=CH₂-, -CH=CH-CH₂-CH₂-, -CH=CH-CH₂-CH₂-CH₂-, -CH=CH-CH=CH- , -CH=CH-CH=CH-CH₂-, -CH=CH-CH=CH-CH₂-CH₂-, -CH=CH-CH₂-CH=CH-, and -CH=CH-CH₂-CH₂-CH=CH-.

Examples of branched partially unsaturated C₁₋₇ alkylene groups include, but are not limited to, -C(CH₃)=CH-, -C(CH₃)=CH-CH₂-, and -CH=CH-CH(CH₃)-.

Partially unsaturated alkylene groups comprising one or more double bonds may be referred to as alkenylene groups. Partially unsaturated alkylene groups comprising one or more triple bonds may be referred to as alkynylene groups (for instance -C=C-, CH₂-C≡C-, and -CH₂-C≡C-CH₂-).

Examples of alicyclic saturated C₁₋₇ alkylene groups include, but are not limited to, cyclopentylene (e.g., cyclopent-1,3-ylene), and cyclohexylene (e.g., cyclohex-1,4-ylene). Examples of alicyclic partially unsaturated C₁₋₇ alkylene groups include, but are not limited to, cyclopentenylene (e.g., 4-cyclopenten-1,3-ylene), cyclohexenylene (e.g., 2-cyclohexen-1,4-ylene; 3-cyclohexen-1,2-ylene; 2,5-cyclohexadien-1,4-ylene). Such groups may also be referred to as "cycloalkylene groups".

The term "arylene group", as used herein, refers to a substituted or unsubstituted bidentate moiety obtained by removing two hydrogen atoms, either both from the same carbon atom, or one from each of two different carbon atoms, of an aryl group, as defined herein. Thus, the term "arylene" includes phenylene, naphthylene, indenylene, indanylene, anthrecenylene and pyrenylene groups, and also heteroarylene groups such as pyridylene, pyrazinylene, pyrimidinylene, pyridazinylene, furanylene, thienylene, pyrazolidinylene, pyrrolylene, oxazolylene, oxadiazolylene, isoxazolylene, thiadiazolylene, thiazolylene, isothiazolylene, imidazolylene, pyrazolylene, quinolylene and isoquinolylene.

The term "substituted", as used herein in the context of substituted organic groups, refers to an organic group which bears one or more substituents selected from C₁₋₁₀ alkyl, aryl (as defined herein), cyano, amino, nitro, C₁₋₁₀ alkylamino, di(C₁₋₁₀)alkylamino, arylamino, diarylamino, aryl(C₁₋₁₀)alkylamino, amido, acylamido, hydroxy, oxo, halo, carboxy, ester, acyl, acyloxy, C₁₋₁₀ alkoxy, aryloxy, halo(C₁₋₁₀)alkyl, sulfonic acid, thiol, C₁₋₁₀ alkylthio, arylthio, sulfonyl, phosphoric acid, phosphate ester, phosphonic acid and phosphonate ester. Examples of substituted alkyl groups include haloalkyl, perhaloalkyl, hydroxyalkyl, aminoalkyl, alkoxyalkyl and alkaryl groups. When a group is substituted, it may bear 1, 2 or 3 substituents. For instance, a substituted group may have 1 or 2 substitutents.

As used herein, the term "ammonium" indicates an organic cation comprising a quaternary nitrogen. An ammonium cation is a cation of formula R¹R²R³R⁴N⁺. R¹, R², R³, and R⁴ are substituents. Each of R¹, R², R³, and R⁴ are typically independently selected from hydrogen, or from optionally substituted alkyl, alkenyl, aryl, cycloalkyl, cycloalkenyl and amino; the optional substituent is preferably an amino or imino substituent. Usually, each of R¹, R², R³, and R⁴ are independently selected from hydrogen, and optionally substituted C₁₋₁₀ alkyl, C₂₋₁₀ alkenyl, C₃₋₁₀ cycloalkyl, C₃₋₁₀ cycloalkenyl, C₆₋₁₂ aryl and C₁₋₆ amino; where present, the optional substituent is preferably an amino group; particularly preferably C₁₋₆ amino. Preferably, each of R¹, R², R³, and R⁴ are independently selected from hydrogen, and unsubstituted C₁₋₁₀ alkyl, C₂₋₁₀ alkenyl, C₃₋₁₀ cycloalkyl, C₃₋₁₀ cycloalkenyl, C₆₋₁₂ aryl and C₁₋₆ amino. In a particularly preferred embodiment, R¹, R², R³, and R⁴ are independently selected from hydrogen, C₁₋₁₀ alkyl, and C₂₋₁₀ alkenyl and C₁₋₆ amino. Further preferably, R¹, R², R³, and R⁴ are independently selected from hydrogen, C₁₋₆ alkyl, C₂₋₆ alkenyl and C₁₋₆ amino.

The term "consisting essentially of" refers to a composition comprising the components of which it consists essentially as well as other components, provided that the other components do not materially affect the essential characteristics of the composition. Typically, a composition consisting essentially of certain components will comprise greater than or equal to 95 wt% of those components or greater than or equal to 99 wt% of those components.

### Optoelectronic material

The invention provides an optoelectronic material comprising a compound, wherein the compound comprises:
(i) one or more cations, A;
(ii) one or more first B cations, Bⁿ⁺, at least one of which is Ag⁺;
(iii) one or more second B cations, B^{m+}, at least one of which is a heptacation, B⁷⁺; and
(iv) one or more chalcogen anions, X;
wherein the one or more first B cations, Bⁿ⁺ are different from the one or more second B cations, B^{m+}; n represents the oxidation state of the first B cation and is a positive integer of from 1 to 7 inclusive; m represents the oxidation state of the second B cation and is a positive integer of from 1 to 7 inclusive; and n + m is equal to 8.

The one or more first B cations, Bⁿ⁺, are a different element or elements to the one or more second B cations, B^{m+}. Typically, the compound is a crystalline compound.

Typically, the optoelectronic material is a photovoltaic material or an electroluminescent material. In one embodiment, the optoelectronic material is a photovoltaic material. In another embodiment, the optoelectronic material is an electroluminescent material.

Typically, at least one of the one or more first cations, Bⁿ⁺, and at least one of the one or more second cations, B^{m+}, have the electronic configuration Nd¹⁰(N+1)s⁰ wherein N is an integer from 3 to 5.

Typically, n is an integer from 1 to 6 inclusive, or from 1 to 5 inclusive, or from 1 to 4 inclusive, or from 1 to 3 inclusive. Typically n is 1 or 2. Typically, m is an integer from 2 to 7 inclusive, or from 3 to 7 inclusive, or from 4 to 7 inclusive, or from 5 to 7 inclusive. Preferably m is 6 or 7. Thus, typically, n is an integer from 1 to 6 inclusive and m is an integer from 2 to 7 inclusive, or n is an integer from 1 to 5 inclusive and m is an integer from 3 to 7 inclusive, or n is an integer from 1 to 4 inclusive and m is an integer from 4 to 7 inclusive, or n is an integer for from 1 to 3 inclusive and m is an integer from 5 to 7 inclusive. Typically, n is 1 or 2 and m is 6 or 7. Preferably, n is 1 and m is 7.

Typically, the band gap of the compound is less than 3.0 eV, or the measured photoluminescence peak is less than 3.0 eV or the onset of optical absorption is less than 3.0 eV. In one embodiment, the band gap of the compound is less than 3.0 eV, the measured photoluminescence peak is less than 3.0 eV and the onset of optical absorption is less than 3.0 eV. Typically, the band gap of the compound is from 1.0 eV to 2.9 eV, or from 1.25 to 2.8 eV, or from 1.5 to 2.7 eV. Typically, the band gap of the compound is from 1.0 eV to 2.5 eV, or from 1.2 to 2.25 eV, or from 1.3 to 2.0 eV. Here, the band gap typically refers to a direct band gap, or a quasi direct band gap. Preferably, it refers to a direct band gap. By quasi-direct band gap is meant that the band gap is indirect but the energy difference between the indirect and direct gaps is smaller than 0.1 eV.

### B cations

In the present invention, at least one of the one or more first B cations, Bⁿ⁺, is Ag⁺. Typically, the one or more first B cations, Bⁿ⁺, additionally comprises one or more monocations, typically one or more inorganic monocations, typically one or more metal monocations. Typically, the one or more first B cations, Bⁿ⁺, additionally comprise noble metal cations and/or alkali metal cations. Noble metals are typically selected from ruthenium (Ru), rhodium (Rh), palladium (Pd), osmium (Os), iridium (Ir), platinum (Pt), gold (Au), mercury (Hg), rhenium (Re) and copper (Cu). Alkali metals are those metals of group 1 of the periodic table, including lithium (Li), sodium (Na), potassium (K), rubidium (Rb), and caesium (Cs). Typically, the one or more first B cations, Bⁿ⁺ additionally comprise one or more of Li⁺, Na⁺, K⁺, Rb⁺, Cs⁺, Cu⁺, Au⁺ and Hg⁺.

The one or more first B cations, Bⁿ⁺, may comprise a single Ag⁺ cation or may comprise multiple cations of charge n+. For instance, the one or more first B cations, Bⁿ⁺, may comprise two cations of charge n+ or three cations of charge n+. At least one of the one or more first B cations, Bⁿ⁺, is Ag⁺. When the one or more first B cations, Bⁿ⁺, comprises multiple cations of charge n+, the one or more first B cations, Bⁿ⁺, may comprise or consist of Ag⁺ and Na⁺, or Ag⁺ and Au⁺, or Ag⁺ and Cu⁺, or Ag⁺ and K⁺. Typically, the one or more first B cations, Bⁿ⁺, comprises or consists of Ag⁺ and Na⁺, or Ag⁺ and Au⁺, or Ag⁺ and Cu⁺ or Ag⁺ and K⁺.

The one or more second B cations, B^{m+}, are, or comprise, one or more heptacations B⁷⁺. Typically, the one or more second B cations, B^{m+}, comprise one or more halogen cations in the +7 oxidation state. Halogens are those elements of group 17 of the periodic table, and include fluorine (F), chlorine (Cl), bromine (Br), iodine (I) and astatine (At). Typically, the one or more second B cations, B^{m+}, comprise one or more halogen cations in the +7 oxidation state selected from chlorine, bromine and iodine, typically bromine or iodine. Preferably, the one or more second B cations, B^{m+}, comprise iodine as I⁷⁺.

The one or more second B cations, B^{m+}, may comprise a single cation or may comprise multiple cations of charge m+. For instance, the one or more second B cations, B^{m+}, may comprise two cations of charge m+ or three cations of charge m+. Typically, at least one of the one or more second B cations, B^{m+}, is I⁷⁺.When the one or more second B cations, B^{m+}, comprises multiple cations of charge m+, the one or more second B cations, B^{m+}, may comprise I⁷⁺ and Br⁷⁺.

In one embodiment, the one or more first B cations, Bⁿ⁺, comprise Ag⁺ and the one or more second B cations, B^{m+}, comprise I⁷⁺.Thus, the compound may comprise a single first B cation which is Ag⁺, and a single second B cation which is I⁷⁺.The compound may comprise multiple first B cations, Bⁿ⁺, and multiple second B cations, B^{m+}, wherein the multiple first B cations, Bⁿ⁺, comprise Ag⁺, and the multiple second B cations, B^{m+}, comprise I⁷⁺.

### A cations

Typically, the one or more cations, A, comprise one or more dications. In one embodiment, the one or more cations, A, consist of one or more dications. In another embodiment, the one or more cations, A, consist of one or more dications and one or more cations of a different charge. For instance, the one or more cations, A, may consist of one or more dications and one or more monocations, or one or more dications and one or more trications, or one or more dications and one or more tetracations.

The one or more cations, A, may comprise a single dication or may comprise multiple dications. For instance, the one or more cations, A, may comprise two dications or three dications.

Typically, the one or more cations, A, comprise one or more inorganic dications or one or more organic dications. The one or more cations, A, may comprise one or more inorganic dications and one or more organic dications.

The one or more inorganic dications may be selected from alkaline earth metal dications, transition metal dications or post-transition metal dications. Typically, the one or more inorganic dications comprise one or more alkaline earth metal dications. Typically, the one or more inorganic dications are selected from Ba²⁺, Sr²⁺, Ca²⁺, Mg²⁺, Pb²⁺, Cd²⁺ and Mn²⁺.

The one or more cations, A, may comprise one or more organic dications. For instance, the one or more organic cations may be diammonium cations.

Diammonium cations typically have the formula:

[(NR²₃)-R¹-(NR²₃)]²⁺

wherein R¹ is selected from an alkylene group, a cycloalkylene group, or an arylene group, and wherein each R² is independently selected from an alkyl group and hydrogen. Typically, R¹ is selected from a C₁₋₁₀ alkylene group, a C₃₋₆ cycloalkylene group and a C₆₋₁₀ arylene group, and each R² is independently selected from a C₁₋₆ alkyl group and hydrogen. For instance, R¹ may be a C₁₋₆ alkylene group, for instance methylene, ethylene, propylene, butylene, pentylene or hexylene, and R² may be hydrogen. Hence, the diammonium cation may be an ethylene diammonium cation ([H₃N(CH₂)₂NH₃]²⁺). Thus, said one or more organic cations comprise an ethylene diammonium cation ([H₃N(CH₂)₂NH₃]²⁺).

When one or more A cations is a monocation, the monocation is typically an inorganic monocation, typically a metal monocation. For instance, the monocation may be an alkali metal cation, for instance an alkali metal cation selected from Na⁺, K⁺, Rb⁺ or Cs⁺, typically Cs⁺. Alternatively, when one or more A cations is a monocation, the monocation may be an organic monocation, typically comprising an ammonium group. For instance, the one or more A cation can comprise an C₁₋₁₀ alkyl ammonium cation, typically a C₁₋₆ alkyl ammonium cation, for instance a hexyl ammonium cation, a pentyl ammonium cation, a butyl ammonium cation, a propyl ammonium cation, an ethyl ammonium cation or a methyl ammonium cation. The one or more A cations may comprise a formamidinium cation (H₂N-C(H)=NH₂)⁺.

When one or more A cations is a tetracation, the tetracation is typically an inorganic tetracation, typically a metal tetracation. For instance, the tetracation may be a transition metal tetracation or a p-block metal tetracation, for instance a tetra cation selected from Ti⁴⁺, Sn⁴⁺, Hf⁴⁺ Zr⁴⁺ and Ge⁴⁺.

### X anions

Typically, the one or more chalcogen anions, X, comprise O²⁻ (oxide), S²⁻ (sulphide), Se²⁻(selenide) or Te²⁻ (telluride). Typically, the one or more chalcogen anions, X, comprise O²⁻, S²⁻ or Se²⁻, preferably O²⁻ or S²⁻.

The one or more chalcogen anions, X, may comprise a single chalcogen anion. For instance, the compound may comprise a single chalcogen anion, X, selected from O²⁻ (oxide), S²⁻ (sulphide), Se²⁻ (selenide) or Te²⁻ (telluride), typically from O²⁻,S²⁻ or Se²⁻, for instance from O²- or S²⁻, for instance O²⁻.

The one or more chalcogen anions, X, may comprise multiple chalcogen anions. For instance, one or more chalcogen anions, X, may comprise two different chalcogen anions. Thus, the one or more chalcogen anions, X, may comprise two chalcogen anions selected from O²⁻ (oxide), S²⁻ (sulphide), Se²⁻ (selenide) or Te²⁻ (telluride). Typically the two chalcogen anions are O²⁻ and S²⁻, or O²⁻ and Se²⁻.

### Double perovskites

In one embodiment, the compound is a double perovskite. Thus, typically the compound is a compound of Formula (I):

[A]₂[Bⁿ⁺][B^{m+}][X]₆ (I);

wherein: [A] is one or more dications, as defined herein; [Bⁿ⁺] is the one or more first B cations, as defined herein; [B^{m+}] is the one or more second B cations, as defined herein; and [X] is the one or more chalcogen anions, as defined herein; wherein n and m represent the oxidation states of the first and second B cations and wherein n is a positive integer of from 1 to 7 inclusive, m is a positive integer of from 1 to 7 inclusive, and n + m = 8.

In one embodiment, the compound is a compound of Formula (IA):

A₂Bⁿ⁺B^{m+}X₆ (IA);

Wherein A is a dication, as defined herein; Bⁿ⁺ is a first B cation, as defined herein; B^{m+} is a second B cation, as defined herein; and X is a chalcogen anion, as defined herein; and wherein n and m represent the oxidation states of the first and second B cations and wherein n is a positive integer of from 1 to 7 inclusive, m is a positive integer of from 1 to 7 inclusive, and n + m = 8.

Typically the compound is Ba₂AgIO₆. Ba₂AgIO₆ may also be referred to as Ba₂IAgO₆ and the two are understood to refer to the same compound with Ag⁺ and I⁷⁺ ions at the B-cation sites.

In another embodiment, the compound is not Ba₂AgIO₆. In any of the embodiments of the invention defined herein, the compound may be other than Ba₂AgIO₆.

The compound according to Formula (I) may be a compound according to Formula IB, IC, ID or IE:

[A¹ₓA²₁₋ₓ]₂Bⁿ⁺B^{m+}X₆ (IB);

A₂[(B¹)ⁿ⁺ₓ(B²)ⁿ⁺₁₋ₓ]B^{m+}X₆ (IC);

A₂Bⁿ⁺[(B¹)^{m+}ₓ(B²)^{m+}₁₋ₓ]X₆ (ID);

A₂Bⁿ⁺B^{m+}[X¹ₓX²₁₋ₓ]₆ (IE);

wherein: A¹ and A² represent two different A dications, as defined herein; (B¹)ⁿ⁺ and (B²)ⁿ⁺ represent two different first B cations, Bⁿ⁺, as defined herein; (B¹)^{m+} and (B²)^{m+} represent two different second B cations, B^{m+}, as defined herein; X¹ and X² represent two different chalcogen anions, X, as defined herein; wherein n and m represent the oxidation states of the first and second B cations and wherein n is a positive integer of from 1 to 7 inclusive, m is a positive integer of from 1 to 7 inclusive, and n + m = 8; and wherein x is greater than 0 and less than 1, typically where x is between 0.05 and 0.95.

Typically, the compound is [BaₓSr₁₋ₓ]AgIO₆, [BaₓPb₁₋ₓ]AgIO₆, Ba₂[AgₓCu₁₋ₓ]IO₆, Ba₂[AgₓNa₁₋ₓ]IO₆, Ba₂[AgₓAu₁₋ₓ]IO₆, Ba₂Ag[IₓBr₁₋ₓ]O₆, Ba₂Ag[IₓBr₁₋ₓ]O₆, Ba₂AgI[OₓS₁₋ₓ]₆, or Ba₂AgI[OₓSe₁₋ₓ]₆, wherein x is greater than 0 and less than 1, typically where x is between 0.05 and 0.95.

The compound of formula I or IA-IE may contain vacancies at the chalcogen anion X sites. For instance, when X comprises O²⁻,the compound of formula I or IA-IE may contain oxide anion vacancies. Therefore, the stoichiometry for the one or more chalcogen anions, X, may be slightly less than that the ideal stoichiometry given in formula I or IA-IE above.

As the skilled person would understand, a deficiency in chalcogen anions means that fewer positive charges are required to balance the negative charges of the chalcogen anions. Thus, charge neutrality may by maintained by a portion of the cations in the compound being in a lower oxidation state, and therefore having a lower positive charge, than would otherwise be the case. Additionally or alternatively, charge neutrality may be maintained by a deficiency in cations, e.g. by corresponding cation vacancies, or by replacing a small number of the B-site cations with cations of a lower oxidation state, for instance replacing I⁷⁺ with Sb⁵⁺. Accordingly, compounds which may be employed in the present invention include chalcogen anion deficient variants of the compounds of any of the formulae defined herein, and in particular include chalcogen anion deficient variants of the compounds of formulae I and IA-IE as defined herein. This includes, for instance, oxide anion deficient variants of the compounds of formulae I and IA-IE as defined herein wherein the one or more chalcogen anions, X, comprise an oxide anion.

A chalcogen anion deficient variant of a compound as defined herein is a variant of the defined compound which has greater than 0% chalcogen anion vacancies. A chalcogen anion deficient variant of a compound as defined herein is typically a variant of the defined compound which has greater than 0% and up to 10% chalcogen anion vacancies, for instance greater than 0% and less than 5% chalcogen anion vacancies, or greater than 0% and less than 1% chalcogen anion vacancies.

In this context a compound with 0% chalcogen anion vacancies is a compound in which each and every one of the chalcogen anion sites in the compound is occupied by a chalcogen anion. A compound with x% chalcogen anion vacancies, on the other hand, where x is a number greater than 0 and less than 100, is a compound in which x% of the chalcogen anion sites in the compound are vacant and each and every one of the other (100-x)% of the chalcogen anion sites in the compound is occupied by a chalcogen anion. Thus, a compound with 2% chalcogen anion vacancies is a compound in which 2% of the chalcogen anion sites in the compound are vacant and each and every one of the other 98% of the chalcogen anion sites in the compound is occupied by a chalcogen anion.

### Layered perovskites

In another embodiment, the compound is a Ruddlesden-Popper phase. Thus, typically, the compound is a compound of Formula II:

[A]₂ₚ₊₂[Bⁿ⁺]ₚ[B^{m+}]ₚ[X]₆ₚ₊₂ (II),

wherein: p is an integer from 1 to 5 inclusive; [A] is one or more dications, as defined herein; [Bⁿ⁺] is the one or more first B cations, as defined herein; [B^{m+}] is the one or more second B cations, as defined herein; and [X] is the one or more chalcogen anions, as defined herein; wherein n and m represent the oxidation states of the first and second B cations and wherein n is a positive integer of from 1 to 7 inclusive, m is a positive integer of from 1 to 7 inclusive, and n + m = 8.

In one embodiment, the compound of Formula II is a compound of Formula IIA:

A₂ₚ₊₂Bⁿ⁺ₚB^{m+}ₚX₆ₚ₊₂ (IIA),

wherein: p is an integer from 1 to 5 inclusive; A is a dication, as defined herein; Bⁿ⁺ is a first B cation, as defined herein; B^{m+} is a second B cation, as defined herein; and X is a chalcogen anion, as defined herein; wherein n and m represent the oxidation states of the first and second B cations and wherein n is a positive integer of from 1 to 7 inclusive, m is a positive integer of from 1 to 7 inclusive, and n + m = 8.

Typically the compound is Ba₄AgIO₈, Ba₆Ag₂I₂O₁₄ or Ba₈Ag₃I₃O₂₀, for instance Ba₄AgIO₈.

The compound according to Formula (II) may be a compound of Formula IIB, IIC, IID or IIE:

[A¹ₓA²₁₋ₓ]₂ₚ₊₂Bⁿ⁺ₚB^{m+}ₚX₆ₚ₊₂ (IIB),

A₂ₚ₊₂[(B¹)ⁿ⁺ₓ(B²)ⁿ⁺₁₋ₓ]ₚB^{m+}ₚX₆ₚ₊₂ (IIC),

A₂ₚ₊₂Bⁿ⁺ₚ[(B¹)^{m+}ₓ(B²)^{m+}₁₋ₓ]ₚX₆ₚ₊₂ (IID),

A₂ₚ₊₂Bⁿ⁺ₚB^{m+}ₚ[X¹ₓX²₁₋ₓ]₆ₚ₊₂ (IIE),

wherein: p is an integer from 1 to 5 inclusive; A¹ and A² represent two different A dications, as defined herein; (B¹)ⁿ⁺ and (B²)ⁿ⁺ represent two different first B cations, Bⁿ⁺, as defined herein; (B¹)^{m+} and (B²)^{m+} represent two different second B cations, B^{m+}, as defined herein; X¹ and X² represent two different chalcogen anions, X, as defined herein; wherein n and m represent the oxidation states of the first and second B cations and wherein n is a positive integer of from 1 to 7 inclusive, m is a positive integer of from 1 to 7 inclusive, and n + m = 8; and wherein x is greater than 0 and less than 1, typically where x is between 0.05 and 0.95.

For instance, the compound may be a compound of Formula IIC which is Ba₂ₚ₊₂[AgₓNa₁₋ₓ]ₚIₚO₆ₚ₊₂, wherein p is an integer from 1 to 5 inclusive and wherein x is greater than 0 and less than 1, typically where x is between 0.05 and 0.95. For instance, the compound may be a compound of formula Ba₆[AgₓNa₁₋ₓ]I₂O₁₄ or Ba₈[AgₓNa₁₋ₓ]₃I₃O₂₀ wherein x is greater than 0 and less than 1, typically where x is between 0.05 and 0.95, for instance Ba₆AgNaI₂O₁₄, or Ba₈Ag₂NaI₃O₂₀.

In formulae II, IIA, IIB, IIC, IID and IIE p may be from 1 to 4 inclusive, or from 1 to 3 inclusive. For instance, p may be an integer selected from 1, 2, 3, 4 or 5, typically 1, 2 or 3.

The compound of formula II or IIA-IIE may comprise vacancies at the chalcogen anion X sites. For instance, when X comprises O²⁻, the compound of formula II or IIA-IIE may comprise oxide anion vacancies. Therefore, the stoichiometry for the one or more chalcogen anions, X, may be slightly less than that the ideal stoichiometry given in formula II or IIA-IIE above. As the skilled person would understand, a deficiency in chalcogen anions means that fewer positive charges are required to balance the negative charges of the chalcogen anions. Thus, charge neutrality may by maintained by a portion of the cations in the compound being in a lower oxidation state, and therefore having a lower positive charge, than would otherwise be the case. Additionally or alternatively, charge neutrality may be maintained by a deficiency in cations, e.g. by corresponding cation vacancies, or by replacing a small number of the B-site cations with cations of a lower oxidation state, for instance replacing I⁷⁺ with Sb⁵⁺. Accordingly, compounds which may be employed in the present invention include chalcogen anion deficient variants of the compounds of any of the formulae defined herein, and in particular chalcogen anion deficient variants of the compounds of formulae II or IIA-IIE, as defined herein. A chalcogen anion deficient variant of a compound as defined herein is a variant of the defined compound which has greater than 0% chalcogen anion vacancies. A chalcogen anion deficient variant of a compound as defined herein is typically a variant of the defined compound which has greater than 0% and up to 10% chalcogen anion vacancies, for instance greater than 0% and less than 5% chalcogen anion vacancies, or greater than 0% and up to 1% chalcogen anion vacancies.

In another embodiment, the compound is a Dion-Jacobson phase. Thus, typically, the compound is a compound of Formula III:

[A⁴⁺]₂[A²⁺]_{2q-2}[Bⁿ⁺]_{q}[B^{m+}]_{q}[X]_{6q+2} (III);

[A⁴⁺]₂[A²⁺]_{2q-2}[Bⁿ⁺]_{q}[B^{m+}]_{q}[X]_{6q+2} (III);

wherein: q is an integer from 1 to 5 inclusive; [A⁴⁺] is one or more tetracations, as defined herein; [A²⁺] is one or more dications; [Bⁿ⁺] is the one or more first B cations; [B^{m+}] is the one or more second B cations; and [X] is the one or more chalcogen anions; wherein n and m represent the oxidation states of the first and second B cations and wherein n is a positive integer of from 1 to 7 inclusive, m is a positive integer of from 1 to 7 inclusive, and n + m = 8.

In one embodiment, the compound of Formula III is a compound of Formula IIIA:

A⁴⁺₂A²⁺_{2q-2}Bⁿ⁺_{q}B^{m+}_{q}X_{6q+2} (IIIA)

wherein: q is an integer from 1 to 5 inclusive; A⁴⁺ an A tetracation, as defined herein; A²⁺ is an A dications, as defined herein; Bⁿ⁺ is a first B cations, as defined herein; B^{m+} is a second B cations, as defined herein; and X is a chalcogen anion, as defined herein; wherein n and m represent the oxidation states of the first and second B cations and wherein n is a positive integer of from 1 to 7 inclusive, m is a positive integer of from 1 to 7 inclusive, and n + m = 8.

For instance, the compound may be a compound of Formula IIIA selected from Zr₂AgIO₈, Hf₂AgIO₈, Sn₂AgIO₈, Zr₂Ba₂Ag₂I₂O₁₄, Hf₂Ba₂Ag₂I₂O₁₄ and Sn₂Ba₂Ag₂I₂O₁₄.

The compound according to Formula III may be a compound of Formula IIIB, IIIC, IIID, IIIE or IIIF:

[(A¹)⁴⁺ₓ(A²)⁴⁺₁₋ₓ]₂A²⁺_{2q-2}Bⁿ⁺_{q}B^{m+}_{q}X_{6q+2} (IIIB),

A⁴⁺₂[(A¹)²⁺ₓ(A²)²⁺₁₋ₓ]_{2q-2}Bⁿ⁺_{q}B^{m+}_{q}X_{6q+2} (IIIC),

A⁴⁺₂A²⁺_{2q-2}[(B¹)ⁿ⁺ₓ(B²)ⁿ⁺₁₋ₓ]_{q}B^{m+}_{q}X_{6q+2} (IIID),

A⁴⁺₂A²⁺_{2q-2}Bⁿ⁺_{q}[(B1)^{m+}ₓ(B²)^{m+}₁₋ₓ]_{q}X_{6q+2} (IIIE),

A⁴⁺₂A²⁺_{2q-2}Bⁿ⁺_{q}B^{m+}_{q}[X¹ₓX²₁₋ₓ]_{6q+2} (IIIF),

wherein: q is an integer from 1 to 5 inclusive; (A¹)⁴⁺ and (A²)⁴⁺ represent two different A tetracations; (A²)²⁺ and (A²)²⁺ represent two different A dications, as defined herein; (B¹)ⁿ⁺ and (B²)ⁿ⁺ represent two different first B cations, Bⁿ⁺, as defined herein; (B¹)^{m+} and (B²)^{m+} represent two different second B cations, B^{m+}, as defined herein; X¹ and X² represent two different chalcogen anions, X, as defined herein; wherein n and m represent the oxidation states of the first and second B cations and wherein n is a positive integer of from 1 to 7 inclusive, m is a positive integer of from 1 to 7 inclusive, and n + m = 8; and wherein x is greater than 0 and less than 1, typically where x is between 0.05 and 0.95.

In formulae III, IIIA, IIIB, IIIC, IIID, IIIEand IIIF q may be from 1 to 4 inclusive, or from 1 to 3 inclusive. For instance, q may be an integer selected from 1, 2, 3, 4 or 5, typically 1, 2 or 3.

The compound of formula III or IIIA-IIIF may comprise vacancies at the chalcogen anion X sites. For instance, when X comprises O²⁻,the compound of formula III or IIIA-IIIF may comprise oxide anion vacancies. Therefore, the stoichiometry for the one or more chalcogen anions, X, may be slightly less than that the ideal stoichiometry given in formula III or IIIA-IIIF above. As the skilled person would understand, a deficiency in chalcogen anions means that fewer positive charges are required to balance the negative charges of the chalcogen anions. Thus, charge neutrality may by maintained by a portion of the cations in the compound being in a lower oxidation state, and therefore having a lower positive charge, than would otherwise be the case. Additionally or alternatively, charge neutrality may be maintained by a deficiency in cations, e.g. by corresponding cation vacancies, or by replacing a small number of the B-site cations with cations of a lower oxidation state, for instance replacing I⁷⁺ with Sb⁵⁺. Accordingly, compounds which may be employed in the present invention include chalcogen anion deficient variants of the compounds of any of the formulae defined herein, and in particular chalcogen anion deficient variants of the compounds of formulae III or IIIA-IIIF, as defined herein. A chalcogen anion deficient variant of a compound as defined herein is a variant of the defined compound which has greater than 0% chalcogen anion vacancies. A chalcogen anion deficient variant of a compound as defined herein is typically a variant of the defined compound which has greater than 0% and up to 10% chalcogen anion vacancies, for instance greater than 0% and less than 5% chalcogen anion vacancies, or greater than 0% and up to 1% chalcogen anion vacancies.

In one embodiment, the compound is a compound of Formula IV:

[A⁺]₄[A²⁺]₂ᵣ[Bⁿ⁺]ᵣ[B^{m+}]ᵣ[X]₆ᵣ₊₂ (IV);

wherein: r is an integer from 1 to 5 inclusive; [A⁺] is one or more monocations, as defined herein; [A²⁺] is one or more dications, as defined herein; [Bⁿ⁺] is the one or more first B cations, as defined herein; [B^{m+}] is the one or more second B cations, as defined herein; and [X] is the one or more chalcogen anions, as defined herein; wherein n and m represent the oxidation states of the first and second B cations and wherein n is a positive integer of from 1 to 7 inclusive, m is a positive integer of from 1 to 7 inclusive, and n + m = 8.

In one embodiment, the compound of Formula IV is a compound of Formula IVA:

A⁺₄A²⁺₂ᵣBⁿ⁺ᵣB^{m+}ᵣX₆ᵣ₊₂ (IVA);

Wherein: A⁺ is an A monocation, as defined herein; A²⁺ is an A dication, as defined herein; Bⁿ⁺ is a first B cation, as defined herein; B^{m+} is a second B cation, as defined herein; and X is the a chalcogen anions, as defined herein; wherein n and m represent the oxidation states of the first and second B cations and wherein n is a positive integer of from 1 to 7 inclusive, m is a positive integer of from 1 to 7 inclusive, and n + m = 8.

For instance, the compound of Formula IVA may be selected from Cs₄Ba₂AgIO₈, Rb₄Ba₂AgIO₈, [CH₃NH₃]₄Ba₂AgIO₈ or [H₂N-C(H)=NH₂]₄Ba₂AgIO₈. Typically, the compound is Cs₄Ba₂AgIO₈.

The compound according to Formula IV may be a compound of Formula IVB, IVC, IVD, IVE or IVF:

[(A¹)⁺ₓ(A²)⁺₁₋ₓ]₄A²⁺₂ᵣBⁿ⁺ᵣB^{m+}ᵣX₆ᵣ₊₂ (IVB);

A⁺₄[(A¹)²⁺ₓ(A²)²⁺₁₋ₓ] ₂ᵣBⁿ⁺ᵣB^{m+}ᵣX₆ᵣ₊₂ (IVC);

A⁺₄A²⁺₂ᵣ[(B¹)ⁿ⁺ₓ(B²)ⁿ⁺₁₋ₓ]ᵣB^{m+}ᵣX₆ᵣ₊₂ (IVD);

A⁺₄A²⁺₂Bⁿ⁺ᵣ[(B¹)^{m+}ₓ(B²)^{m+}₁₋ₓ]ᵣX₆ᵣ₊₂ (IVE);

A⁺₄A²⁺₂ᵣBⁿ⁺ᵣB^{m+}ᵣ[X¹ₓX²₁₋ₓ]₆ᵣ₊₂ (IVF);

wherein: r is an integer from 1 to 5 inclusive; (A¹)⁺ and (A²)⁺ represent two different A monocations; (A²)²⁺ and (A²)²⁺ represent two different A dications, as defined herein; (B¹)ⁿ⁺ and (B²)ⁿ⁺ represent two different first B cations, Bⁿ⁺, as defined herein; (B¹)^{m+} and (B²)^{m+} represent two different second B cations, B^{m+}, as defined herein; X¹ and X² represent two different chalcogen anions, X, as defined herein; wherein n and m represent the oxidation states of the first and second B cations and wherein n is a positive integer of from 1 to 7 inclusive, m is a positive integer of from 1 to 7 inclusive, and n + m = 8; and wherein x is greater than 0 and less than 1, typically where x is between 0.05 and 0.95.

In formulae IV, IVA, IVB, IVC, IVD, IVE and IVF r may be from 1 to 4 inclusive, or from 1 to 3 inclusive. For instance, r may be an integer selected from 1, 2, 3, 4 or 5, typically 1, 2 or 3.

The compound of formula IV or IVA-IVF may comprise vacancies at the chalcogen anion X sites. For instance, when X comprises O²⁻,the compound of formula IV or IVA-IVF may comprise oxide anion vacancies. Therefore, the stoichiometry for the one or more chalcogen anions, X, may be slightly less than that the ideal stoichiometry given in formula IV or IVA-IVF above. As the skilled person would understand, a deficiency in chalcogen anions means that fewer positive charges are required to balance the negative charges of the chalcogen anions. Thus, charge neutrality may by maintained by a portion of the cations in the compound being in a lower oxidation state, and therefore having a lower positive charge, than would otherwise be the case. Additionally or alternatively, charge neutrality may be maintained by a deficiency in cations, e.g. by corresponding cation vacancies, or by replacing a small number of the B-site cations with cations of a lower oxidation state, for instance replacing I⁷⁺ with Sb⁵⁺. Accordingly, compounds which may be employed in the present invention include chalcogen anion deficient variants of the compounds of any of the formulae defined herein, and in particular chalcogen anion deficient variants of the compounds of formulae IV or IVA-IVF, as defined herein. A chalcogen anion deficient variant of a compound as defined herein is a variant of the defined compound which has greater than 0% chalcogen anion vacancies. A chalcogen anion deficient variant of a compound as defined herein is typically a variant of the defined compound which has greater than 0% and up to 10% chalcogen anion vacancies, for instance greater than 0% and less than 5% chalcogen anion vacancies, or greater than 0% up to 1% chalcogen anion vacancies.

Hence, the compound in the optoelectronic material may be a compound as defined herein, for instance the compound of the present invention as defined below, or the compound as defined for the photocatalyst of the present invention or the compound as defined for the semiconductor device of the present invention.

### Compound

The present invention also provides a compound comprising:
(v) One or more cations, A, as defined herein;
(vi) One or more monocations, B⁺, wherein one of said one or more monocations is Ag⁺;
(vii) One or more heptacations, B⁷⁺, as defined herein; and
(viii) One or more chalcogen anions, X, as defined herein.

The one or more monocations, B+, may additionally comprise any B monocation as defined herein. For instance, the one or more monocations, B⁺, may comprise a single monocation that is Ag⁺, or the one or more monocations, B⁺, may comprise multiple monocations wherein one of said monocations is Ag⁺. For instance, the one or more monocations, B⁺, may comprise two monocations or three monocations, wherein one of said two or three monocations is Ag⁺.

Typically, when the one or more monocations, B⁺, comprise multiple monocations, the one or more monocations, B⁺, comprise noble metal cations and/or alkali metal cations. Noble metals are typically selected from ruthenium, rhodium, palladium, silver, osmium, iridium, platinum, gold, mercury, rhenium and copper. Alkali metals are those metals of group 1 of the periodic table, including lithium, sodium, potassium, rubidium, caesium and francium. Typically, the one or more first monocations, B⁺ comprise one or more of Li⁺, Na⁺, K⁺, Rb⁺, Cs⁺, Cu⁺, Au⁺ and Hg⁺. For instance, the one or more monocations, B⁺, may comprise Ag⁺ and Na⁺, or Ag⁺ and Au⁺, or Ag⁺ and Cu⁺ or Ag⁺ and K⁺.

Typically, the one or more heptacations, B⁷⁺, comprise one or more halogen cations in the +7 oxidation state. Halogens are those elements of group 17 of the periodic table, and include fluorine, chlorine, bromine, iodine and astatine. Typically, the one or more heptacations, B⁷⁺, comprise one or more halogen cations in the +7 oxidation state selected from chlorine, bromine and iodine, typically bromine or iodine. Preferably, the one or more heptacations, B⁷⁺, comprise iodine as I⁷⁺.

The one or more heptacations, B⁷⁺, may comprise a single heptacation or may comprise multiple heptacations. For instance, the one or more heptacations, B⁷⁺, may comprise two heptacations or three heptacations. Typically, at least one of the one or more heptacations, B⁷⁺, is I⁷⁺.When the one or more heptacations, B⁷⁺, comprises multiple heptacations, the one or more heptacations, B⁷⁺, may comprise I⁷⁺ and Br⁷⁺.

In one embodiment, the compound of the invention may comprise a single first B cation, Ag⁺, and a single second B cation I⁷⁺.The compound may comprise multiple first B cations, Bⁿ⁺, and multiple second B cations, B^{m+}, wherein the multiple first B cations, Bⁿ⁺, comprise Ag⁺, and the multiple second B cations, B^{m+}, comprise I⁷⁺.

The one or more cations, A, and the one or more chalcogen anions, X, are as defined as defined herein, for instance as defined above for the optoelectronic material.

In one embodiment, the compound is a double perovskite. Thus, typically the compound is a compound of Formula (I):

[A]₂[B⁺][B⁷⁺][X]₆ (I);

wherein: [A] is one or more dications, as defined herein; [B⁺] is the one or more monocations, as defined herein, wherein one of said one or more monocations is Ag⁺; [B⁷⁺] is the one or more heptacations, as defined herein; and [X] is the one or more chalcogen anions, as defined herein.

In one embodiment, the compound is a compound of Formula (IA):

A₂AgB⁷⁺X₆ (IA);

Wherein A is a dication, as defined herein; B⁷⁺ is a heptacation, as defined herein; and X is a chalcogen anion, as defined herein. Typically, B⁷⁺ is I⁷⁺.Thus, typically the compound is Ba₂AgIO₆. In another embodiment, the compound is not Ba₂AgIO₆. In any of the embodiments of the invention defined herein, the compound may be other than Ba₂AgIO₆.

The compound according to Formula (I) may be a compound according to Formula IB, IC, ID or IE:

[A¹ₓA²_{1-x] 2}AgB⁷⁺X₆ (IB);

A₂[AgₓB⁺₁₋ₓ]B⁷⁺X₆ (IC);

A₂Ag[(B¹)⁷⁺ₓ(B²)⁷⁺₁₋ₓ]X₆ (ID);

A₂AgB⁷⁺[X¹ₓX²₁₋ₓ]₆ (IE);

wherein: A¹ and A² represent two different A dications, as defined herein; B⁺ represents a B monocation, B⁺, as defined herein; (B¹)⁷⁺ and (B²)⁷⁺ represent two different heptacations, B⁷⁺, as defined herein; X¹ and X² represent two different chalcogen anions, X, as defined herein; and wherein x is greater than 0 and less than 1, typically where x is between 0.05 and 0.95.

Typically, the compound is [BaₓSr₁₋ₓ]AgIO₆, [BaₓPb₁₋ₓ]AgIO₆, Ba₂[AgₓCu₁₋ₓ]IO₆, Ba₂[AgₓNa₁₋ₓ]IO₆, Ba₂[AgₓAu₁₋ₓ]IO₆, Ba₂Ag[IₓBr₁₋ₓ]O₆, Ba₂Ag[IₓBr₁₋ₓ]O₆, Ba₂AgI[OₓS₁₋ₓ]₆, or Ba₂AgI[OₓSe₁₋ₓ]₆, wherein x is greater than 0 and less than 1, typically where x is from 0.05 and 0.95.

The compound of formula I or IA-IE may comprise vacancies at the chalcogen anion X sites. For instance, when X comprises O²⁻,the compound of formula I or IA-IE may comprise oxide anion vacancies. Therefore, the stoichiometry for the one or more chalcogen anions, X, may be slightly less than that the ideal stoichiometry given in formula I or IA-IE above. As the skilled person would understand, a deficiency in chalcogen anions means that fewer positive charges are required to balance the negative charges of the chalcogen anions. Thus, charge neutrality may by maintained by a portion of the cations in the compound being in a lower oxidation state, and therefore having a lower positive charge, than would otherwise be the case. Additionally or alternatively, charge neutrality may be maintained by a deficiency in cations, e.g. by corresponding cation vacancies, or by replacing a small number of the B-site cations with cations of a lower oxidation state, for instance replacing I⁷⁺ with Sb⁵⁺. Accordingly, compounds of the present invention include chalcogen anion deficient variants of the compounds of any of the formulae defined herein, and in particular chalcogen anion deficient variants of the compounds of formulae I or IA-IE, as defined above. A chalcogen anion deficient variant of a compound of one of the formulae defined herein is a variant of the defined compound which has greater than 0% chalcogen anion vacancies. A chalcogen anion deficient variant of a compound as defined herein is typically a variant of the defined compound which has greater than 0% and up to 10% chalcogen anion vacancies, for instance greater than 0% and less than 5% chalcogen anion vacancies, or greater than 0% up to 1% chalcogen anion vacancies.

In another embodiment, the compound is a Ruddlesden-Popper phase. Thus, typically, the compound is a compound of Formula II:

[A]₂ₚ₊₂[B⁺]ₚ[B⁷⁺]ₚ[X]₆ₚ₊₂ (II),

wherein: p is an integer from 1 to 5 inclusive; [A] is one or more dications, as defined herein; [B⁺] is the one or more monocations, as defined herein, wherein one of said one or more monocations is Ag⁺; [B⁷⁺] is the one or more heptacations, as defined herein; and [X] is the one or more chalcogen anions, as defined herein.

In one embodiment, the compound of Formula II is a compound of Formula IIA:

A₂ₚ₊₂AgₚB⁷⁺ₚX₆ₚ₊₂ (IIA),

wherein: p is an integer from 1 to 5 inclusive; A is a dication, as defined herein; B⁷⁺ is a second B cation, as defined herein; and X is a chalcogen anions, as defined herein. Typically, B⁷⁺ is I⁷⁺.Thus, typically the compound is Ba₄AgIO₈, Ba₆Ag₂I₂O₁₄ or Ba₈Ag₃I₃O₂₀, for instance Ba₄AgIO₈.

The compound according to Formula II may be a compound of Formula IIB, IIC, IID or IIE:

[A¹ₓA²₁₋ₓ]₂ₚ₊₂AgₚB⁷⁺ₚX₆ₚ₊₂ (IIB),

A₂ₚ₊₂[AgₓB⁺₁₋ₓ]ₚB⁷⁺ₚX₆ₚ₊₂ (IIC),

A₂ₚ₊₂Agₚ[(B¹)⁷⁺ₓ(B²)⁷⁺₁₋ₓ]ₚX₆ₚ₊₂ (IID),

A₂ₚ₊₂AgₚB⁷⁺ₚ[X¹ₓX²₁₋ₓ]₆ₚ₊₂ (IIE),

wherein: p is an integer from 1 to 5 inclusive; A¹ and A² represent two different A dications, as defined herein; B⁺ represents a B monocation, as defined herein; (B¹)⁷⁺ and (B²)⁷⁺ represent two different heptacations, B⁷⁺, as defined herein; X¹ and X² represent two different chalcogen anions, X, as defined herein; and wherein x is greater than 0 and less than 1, typically where x is between 0.05 and 0.95.

For instance, the compound may be a compound of Formula IIC which is Ba₂ₚ₊₂[AgₓNa₁₋ₓ]ₚIₚO₆ₚ₊₂, wherein p is an integer from 1 to 5 inclusive and wherein x is greater than 0 and less than 1, typically where x is between 0.05 and 0.95. For instance, the compound may be a compound of formula Ba₆[AgₓNa₁₋ₓ]I₂O₁₄ or Ba₈[AgₓNa₁₋ₓ]₃I₃O₂₀ wherein x is greater than 0 and less than 1, typically where x is between 0.05 and 0.95, for instance Ba₆AgNaIO₁₄, or Ba₈Ag₂NaI₃O₂₀.

In formulae II, IIA, IIB, IIC, IID and IIE p may be from 1 to 4 inclusive, or from 1 to 3 inclusive. For instance, p may be an integer selected from 1, 2, 3, 4 or 5, typically 1, 2 or 3.

The compound of formula II or IIA-IIE may comprise vacancies at the chalcogen anion X sites. For instance, when X comprises O²⁻,the compound of formula II or IIA-IIE may comprise oxide anion vacancies. Therefore, the stoichiometry for the one or more chalcogen anions, X, may be slightly less than that the ideal stoichiometry given in formula II or IIA-IIE above. As the skilled person would understand, a deficiency in chalcogen anions means that fewer positive charges are required to balance the negative charges of the chalcogen anions. Thus, charge neutrality may by maintained by a portion of the cations in the compound being in a lower oxidation state, and therefore having a lower positive charge, than would otherwise be the case. Additionally or alternatively, charge neutrality may be maintained by a deficiency in cations, e.g. by corresponding cation vacancies, or by replacing a small number of the B-site cations with cations of a lower oxidation state, for instance replacing I⁷⁺ with Sb⁵⁺. Accordingly, compounds of the present invention include chalcogen anion deficient variants of the compounds of any of the formulae defined herein, and in particular chalcogen anion deficient variants of the compounds of formulae II or IIA-IIE, as defined above. A chalcogen anion deficient variant of a compound of one of the formulae defined herein is a variant of the defined compound which has greater than 0% chalcogen anion vacancies. A chalcogen anion deficient variant of a compound as defined herein is typically a variant of the defined compound which has greater than 0% and up to 10% chalcogen anion vacancies, for instance greater than 0% and less than 5% chalcogen anion vacancies, or greater than 0% up to 1% chalcogen anion vacancies.

In another embodiment, the compound is a Dion-Jacobson phase. Thus, typically, the compound is a compound of Formula III:

[A⁴⁺]₂[A²⁺]_{2q-2}[B⁺]_{q}[B⁷⁺]_{q}[X]_{6q+2} (III);

wherein: q is an integer from 1 to 5 inclusive; [A⁴⁺] is one or more tetracations, as defined herein; [A²⁺] is one or more dications, as defined herein; [B⁺] is the one or more monocations, as defined herein, wherein one of said one or more monocations is Ag⁺; [B⁷⁺] is the one or more heptacations, as defined herein; and [X] is the one or more chalcogen anions, as defined herein.

In one embodiment, the compound of Formula III is a compound of Formula IIIA:

A⁴⁺₂A²⁺_{2q-2}B⁺_{q}B⁷⁺_{q}X_{6q+2} (IIIA)

wherein: q is an integer from 1 to 5 inclusive; A⁴⁺ an A tetracation, as defined herein; A²⁺ is an A dications, as defined herein; Bⁿ⁺ is a first B cations, as defined herein; B^{m+} is a second B cations, as defined herein; and X is a chalcogen anion, as defined herein; wherein n and m represent the oxidation states of the first and second B cations and wherein n is a positive integer of from 1 to 7 inclusive, m is a positive integer of from 1 to 7 inclusive, and n + m = 8.

For instance, the compound may be a compound of Formula IIIA selected from Zr₂AgIO₈, Hf₂AgIO₈, Sn₂AgIO₈, Zr₂Ba₂Ag₂I₂O₁₄, Hf₂Ba₂Ag₂I₂O₁₄ and Sn₂Ba₂Ag₂I₂O₁₄.

The compound according to Formula III may be a compound of Formula IIIB, IIIC, IIID, IIIE or IIIF:

[(A¹)⁴⁺ₓ(A²)⁴⁺₁₋ₓ]₂A²⁺_{2q-2}Ag_{q}B⁷⁺_{q}X_{6q+2} (IIIB),

A⁴⁺₂[(A¹)²⁺ₓ(A²)²⁺_{1-x]2q-2}Ag_{q}B⁷⁺_{q}X_{6q+2} (IIIC),

A⁴⁺₂A²⁺_{2q-2}[(AgxB⁺₁₋ₓ]_{q}B⁷⁺_{q}X_{6q+2} (IIID),

A⁴⁺₂A²⁺_{2q-2}Ag_{q}[(B¹)⁷⁺ₓ(B²)⁷⁺₁₋ₓ]_{q}X_{6q+2} (IIIE),

A⁴⁺₂A²⁺_{2q-2}Ag_{q}B⁷⁺_{q}[X¹ₓX²₁-ₓ]_{6q+2} (IIIF),

wherein: q is an integer from 1 to 5 inclusive; (A¹)⁴⁺ and (A²)⁴⁺ represent two different A tetracations, as defined herein; (A²)²⁺ and (A²)²⁺ represent two different A dications, as defined herein; B⁺ represents a monocation, as defined herein; (B¹)⁷⁺ and (B²)⁷⁺ represent two different heptacations, B⁷⁺, as defined herein; X¹ and X² represent two different chalcogen anions, X, as defined herein; and wherein x is greater than 0 and less than 1, typically where x is between 0.05 and 0.95.

In formulae III, IIIA, IIIB, IIIC, IIID, IIIEand IIIF q may be from 1 to 4 inclusive, or from 1 to 3 inclusive. For instance, q may be an integer selected from 1, 2, 3, 4 or 5, typically 1, 2 or 3.

The compound of formula III or IIIA-IIIF may comprise vacancies at the chalcogen anion X sites. For instance, when X comprises O²⁻, the compound of formula III or IIIA-IIIF may comprise oxide anion vacancies. Therefore, the stoichiometry for the one or more chalcogen anions, X, may be slightly less than that the ideal stoichiometry given in formula III or IIIA-IIIF above. As the skilled person would understand, a deficiency in chalcogen anions means that fewer positive charges are required to balance the negative charges of the chalcogen anions. Thus, charge neutrality may by maintained by a portion of the cations in the compound being in a lower oxidation state, and therefore having a lower positive charge, than would otherwise be the case. Additionally or alternatively, charge neutrality may be maintained by a deficiency in cations, e.g. by corresponding cation vacancies, or by replacing a small number of the B-site cations with cations of a lower oxidation state, for instance replacing I⁷⁺ with Sb⁵⁺. Accordingly, compounds of the present invention include chalcogen anion deficient variants of the compounds of any of the formulae defined herein, and in particular chalcogen anion deficient variants of the compounds of formulae III or IIIA-IIIF, as defined above. A chalcogen anion deficient variant of a compound of one of the formulae defined herein is a variant of the defined compound which has greater than 0% chalcogen anion vacancies. A chalcogen anion deficient variant of a compound as defined herein is typically a variant of the defined compound which has greater than 0% and up to 10% chalcogen anion vacancies, for instance greater than 0% and less than 5% chalcogen anion vacancies, or greater than 0% up to 1% chalcogen anion vacancies.

In one embodiment, the compound is a compound of Formula IV:

[A⁺]₄[A²⁺]₂ᵣ[B⁺]ᵣ[B⁷⁺]ᵣ[X]₆ᵣ₊₂ (IV);

wherein: r is an integer from 1 to 5 inclusive; [A⁺] is one or more monocations, as defined herein; [A²⁺] is one or more dications, as defined herein; [B⁺] is the one or more monocations, as defined herein, wherein one of said one or more first cations is Ag⁺; [B⁷⁺] is the one or more heptacations; and [X] is the one or more chalcogen anions, as defined herein.

In one embodiment, the compound of Formula IV is a compound of Formula IVA:

A⁺₄A²⁺₂ᵣAgᵣB⁷⁺ᵣX₆ᵣ₊₂ (IVA);

Wherein: A⁺ is an A monocation, as defined herein; A²⁺ is an A dication, as defined herein; B⁷⁺ is a heptacation, as defined herein; and X is the a chalcogen anions, as defined herein.

For instance, the compound of Formula IVA may be selected from Cs₄Ba₂AgIO₈, Rb₄Ba₂AgIO₈, [CH₃NH₃]₄Ba₂AgIO₈ or [H₂N-C(H)=NH₂]₄Ba₂AgIO₈. Typically, the compound is Cs₄Ba₂AgIO₈.

The compound according to Formula IV may be a compound of Formula IVB, IVC, IVD, IVE or IVF:

[(A¹)⁺ₓ(A²)⁺₁₋ₓ]₄A²⁺₂ᵣAgᵣB⁷⁺ᵣX₆ᵣ₊₂ (IVB);

A⁺₄[(A¹)²⁺ₓ(A²)²⁺₁₋ₓ] ₂ᵣAgᵣB⁷⁺ᵣX₆ᵣ₊₂ (IVC);

A⁺₄A²⁺₂ᵣ[Agₓ(B²)ⁿ⁺₁₋ₓ]ᵣB⁷⁺ᵣX₆ᵣ₊₂ (IVD);

A⁺₄A²⁺₂Agᵣ[(B¹)⁷⁺ₓ(B²)⁷⁺₁₋ₓ]ᵣX₆ᵣ₊₂ (IVE);

A⁺₄A²⁺₂ᵣAgᵣB⁷⁺ᵣ[X¹ₓX²₁₋ₓ]₆ᵣ₊₂ (IVF);

wherein: r is an integer from 1 to 5 inclusive; (A¹)⁺ and (A²)⁺ represent two different A monocations; (A²)²⁺ and (A²)²⁺ represent two different A dications, as defined herein; B⁺ represents a monocation, as defined herein; (B¹)⁷⁺ and (B²)⁷⁺ represent two different heptacations, B⁷⁺, as defined herein; X¹ and X² represent two different chalcogen anions, X, as defined herein; and wherein x is greater than 0 and less than 1, typically where x is between 0.05 and 0.95.

In formulae IV, IVA, IVB, IVC, IVD, IVE and IVF r may be from 1 to 4 inclusive, or from 1 to 3 inclusive. For instance, r may be an integer selected from 1, 2, 3, 4 or 5, typically 1, 2 or 3.

The compound of formula IV or IVA-IVF may comprise vacancies at the chalcogen anion X sites. For instance, when X comprises O²⁻,the compound of formula IV or IIIA-IVF may comprise oxide anion vacancies. Therefore, the stoichiometry for the one or more chalcogen anions, X, may be slightly less than that the ideal stoichiometry given in formula IV or IVA-IVF above. As the skilled person would understand, a deficiency in chalcogen anions means that fewer positive charges are required to balance the negative charges of the chalcogen anions. Thus, charge neutrality may by maintained by a portion of the cations in the compound being in a lower oxidation state, and therefore having a lower positive charge, than would otherwise be the case. Additionally or alternatively, charge neutrality may be maintained by a deficiency in cations, e.g. by corresponding cation vacancies, or by replacing a small number of the B-site cations with cations of a lower oxidation state, for instance replacing I⁷⁺ with Sb⁵⁺. Accordingly, compounds of the present invention include chalcogen anion deficient variants of the compounds of any of the formulae defined herein, and in particular chalcogen anion deficient variants of the compounds of formulae IV or IVA-IVF, as defined above. A chalcogen anion deficient variant of a compound of one of the formulae defined herein is a variant of the defined compound which has greater than 0% chalcogen anion vacancies. A chalcogen anion deficient variant of a compound as defined herein is typically a variant of the defined compound which has greater than 0% and up to 10% chalcogen anion vacancies, for instance greater than 0% and less than 5% chalcogen anion vacancies, or greater than 0% up to 1% chalcogen anion vacancies.

### Photocatalyst

The present invention also provides photocatalyst material comprising a compound, wherein the compound comprises:
(v) one or more cations, A, as defined herein;
(vi) one or more first B cations, Bⁿ⁺, at least one of which is Ag⁺, as defined herein;
(vii) one or more second B cations, B^{m+}, at least one of which is a heptacation, B⁷⁺, as defined herein; and
(viii) one or more chalcogen anions, X, as defined herein;
wherein the one or more first B cations, Bⁿ⁺ are different from the one or more second B cations, B^{m+}; n represents the oxidation state of the first B cation and is 1 or 2; m represents the oxidation state of the second B cation and is 6 or 7; and n + m is equal to 8. Typically, n is 1 and m is 7.

Hence, the compound in the photocatalyst material may be a compound as defined herein, for instance the compound as defined for the optoelectronic material of the present invention, wherein n is 1 or 2 and m is 6 or 7, the compound of the present invention or the compound as defined for the semiconductor device of the present invention, wherein n is 1 or 2 and m is 6 or 7.

In one embodiment, the compound is a double perovskite. Thus, typically the compound is a compound of Formula (I):

[A]₂[Bⁿ⁺][B^{m+}][X]₆ (I);

wherein: [A] is one or more dications, as defined herein; [Bⁿ⁺] is the one or more first B cations, as defined herein; [B^{m+}] is the one or more second B cations, as defined herein; and [X] is the one or more chalcogen anions, as defined herein; wherein n represents the oxidation state of the first B cation and is 1 or 2; m represents the oxidation state of the second B cation and is 6 or 7; and n + m is equal to 8.

In one embodiment, the compound is a compound of Formula (IA):

A₂Bⁿ⁺B^{m+}X₆ (IA);

Wherein A is a dication, as defined herein; Bⁿ⁺ is a first B cation, as defined herein; B^{m+} is a second B cation, as defined herein; and X is a chalcogen anion, as defined herein; and wherein n represents the oxidation state of the first B cation and is 1 or 2; m represents the oxidation state of the second B cation and is 6 or 7; and n + m is equal to 8.

Typically the compound is Ba₂AgIO₆. In another embodiment, the compound is not Ba₂AgIO₆. In any of the embodiments of the invention defined herein, the compound may be other than Ba₂AgIO₆.

The compound according to Formula (I) may be a compound according to Formula IB, IC, ID or IE:

[A^{I}ₓA²₁₋ₓ]₂Bⁿ⁺B^{m+}X₆ (IB);

A₂[(B¹)ⁿ⁺ₓ(B²)ⁿ⁺₁₋ₓ]B^{m+}X₆ (IC);

A₂Bⁿ⁺[(B¹)^{m+}ₓ(B²)^{m+}₁₋ₓ]X₆ (ID);

A₂Bⁿ⁺B^{m+}[X¹ₓX²₁₋ₓ]₆ (IE);

wherein: A¹ and A² represent two different A dications, as defined herein; (B¹)ⁿ⁺ and (B²)ⁿ⁺ represent two different first B cations, Bⁿ⁺, as defined herein; (B¹)^{m+} and (B²)^{m+} represent two different second B cations, B^{m+}, as defined herein; X¹ and X² represent two different chalcogen anions, X, as defined herein; wherein n represents the oxidation state of the first B cation and is 1 or 2; m represents the oxidation state of the second B cation and is 6 or 7; and n + m is equal to 8. and wherein x is greater than 0 and less than 1, typically where x is between 0.05 and 0.95.

Typically, the compound is [BaₓSr₁₋ₓ]AgIO₆, [BaₓPb₁₋ₓ]AgIO₆, Ba₂[AgₓCu₁₋ₓ]IO₆, Ba₂[AgₓNa₁₋ₓ]IO₆, Ba₂[AgₓAu₁₋ₓ]IO₆, Ba₂Ag[IₓBr₁₋ₓ]O₆, Ba₂Ag[IₓBr₁₋ₓ]O₆, Ba₂AgI[OₓS₁₋ₓ]₆, or Ba₂AgI[OₓSe₁₋ₓ]₆, wherein x is greater than 0 and less than 1, typically where x is between 0.05 and 0.95.

The compound of formula I or IA-IE may comprise vacancies at the chalcogen anion X sites. For instance, when X comprises O²⁻,the compound of formula I or IA-IE may comprise oxide anion vacancies. Therefore, the stoichiometry for the one or more chalcogen anions, X, may be slightly less than that the ideal stoichiometry given in formula I or IA-IE above. As the skilled person would understand, a deficiency in chalcogen anions means that fewer positive charges are required to balance the negative charges of the chalcogen anions. Thus, charge neutrality may by maintained by a portion of the cations in the compound being in a lower oxidation state, and therefore having a lower positive charge, than would otherwise be the case. Additionally or alternatively, charge neutrality may be maintained by a deficiency in cations, e.g. by corresponding cation vacancies, or by replacing a small number of the B-site cations with cations of a lower oxidation state, for instance replacing I⁷⁺ with Sb⁵⁺. Accordingly, compounds which may be employed in the present invention include chalcogen anion deficient variants of the compounds of any of the formulae defined herein, and in particular chalcogen anion deficient variants of the compounds of formulae I or IA-IE above. A chalcogen anion deficient variant of a compound as defined herein is a variant of the defined compound which has greater than 0% chalcogen anion vacancies. A chalcogen anion deficient variant of a compound as defined herein is typically a variant of the defined compound which has greater than 0% and up to 10% chalcogen anion vacancies, for instance greater than 0% and less than 5% chalcogen anion vacancies, or greater than 0% and up to 1% chalcogen anion vacancies.

In another embodiment, the compound is a Ruddlesden-Popper phase. Thus, typically, the compound is a compound of Formula II:

[A]₂ₚ₊₂[Bn⁺]ₚ[B^{m+}]ₚ[X]₆ₚ₊₂ (II),

wherein: p is an integer from 1 to 5 inclusive; [A] is one or more dications, as defined herein; [Bⁿ⁺] is the one or more first B cations, as defined herein; [B^{m+}] is the one or more second B cations, as defined herein; and [X] is the one or more chalcogen anions, as defined herein; wherein n represents the oxidation state of the first B cation and is 1 or 2; m represents the oxidation state of the second B cation and is 6 or 7; and n + m is equal to 8.

In one embodiment, the compound of Formula II is a compound of Formula IIA:

A₂ₚ+₂Bⁿ⁺ₚB^{m+}ₚX₆ₚ₊₂ (IIA),

wherein: p is an integer from 1 to 5 inclusive; A is a dication, as defined herein; Bⁿ⁺ is a first B cation, as defined herein; B^{m+} is a second B cation, as defined herein; and X is a chalcogen anions, as defined herein; wherein n represents the oxidation state of the first B cation and is 1 or 2; m represents the oxidation state of the second B cation and is 6 or 7; and n + m is equal to 8.

### Typically the compound is Ba₄AgIO₈, Ba₆Ag₂I₂O₁₄ or Ba₈Ag₃I₃O₂₀, for instance Ba₄AgIO₈.

The compound according to Formula (II) may be a compound of Formula IIB, IIC, IID or IIE:

[A¹ₓA²₁₋ₓ]₂ₚ₊₂Bⁿ⁺ₚB^{m+}ₚX₆ₚ₊₂ (IIB),

A₂ₚ₊₂[(B¹)ⁿ⁺ₓ(B²)ⁿ⁺₁₋ₓ]ₚB^{m+}ₚX₆ₚ₊₂ (IIC),

A₂ₚ₊₂Bⁿ⁺ₚ[(B¹)^{m+}ₓ(B²)^{m+}₁₋ₓ]ₚX₆ₚ₊₂ (IID),

A₂ₚ₊₂Bⁿ⁺ₚB^{m+}ₚ[X¹ₓX²₁₋ₓ]₆ₚ₊₂ (IIE),

wherein: p is an integer from 1 to 5 inclusive; A¹ and A² represent two different A dications, as defined herein; (B¹)ⁿ⁺ and (B²)ⁿ⁺ represent two different first B cations, Bⁿ⁺, as defined herein; (B¹)^{m+} and (B²)^{m+} represent two different second B cations, B^{m+}, as defined herein; X¹ and X² represent two different chalcogen anions, X, as defined herein; wherein n represents the oxidation state of the first B cation and is 1 or 2; m represents the oxidation state of the second B cation and is 6 or 7; and n + m is equal to 8; and wherein x is greater than 0 and less than 1, typically where x is between 0.05 and 0.95.

For instance, the compound may be a compound of Formula IIC which is Ba₂ₚ₊₂[AgₓNa₁₋ₓ]ₚIₚO₆ₚ₊₂, wherein p is an integer from 1 to 5 inclusive and wherein x is greater than 0 and less than 1, typically where x is between 0.05 and 0.95. For instance, the compound may be a compound of formula Ba₆[AgₓNa₁₋ₓ]I₂O₁₄ or Ba₈[AgₓNa₁₋ₓ]₃I₃O₂₀ wherein x is greater than 0 and less than 1, typically where x is between 0.05 and 0.95, for instance Ba₆AgNaI₂O₁₄, or Ba₈Ag₂NaI₃O₂₀.

In formulae II, IIA, IIB, IIC, IID and IIE p may be from 1 to 4 inclusive, or from 1 to 3 inclusive. For instance, p may be an integer selected from 1, 2, 3, 4 or 5, typically 1, 2 or 3.

The compound of formula II or IIA-IIE may comprise vacancies at the chalcogen anion X sites. For instance, when X comprises O²⁻,the compound of formula II or IIA-IIE may comprise oxide anion vacancies. Therefore, the stoichiometry for the one or more chalcogen anions, X, may be slightly less than that the ideal stoichiometry given in formula II or IIA-IIE above. As the skilled person would understand, a deficiency in chalcogen anions means that fewer positive charges are required to balance the negative charges of the chalcogen anions. Thus, charge neutrality may by maintained by a portion of the cations in the compound being in a lower oxidation state, and therefore having a lower positive charge, than would otherwise be the case. Additionally or alternatively, charge neutrality may be maintained by a deficiency in cations, e.g. by corresponding cation vacancies, or by replacing a small number of the B-site cations with cations of a lower oxidation state, for instance replacing I⁷⁺ with Sb⁵⁺. Accordingly, compounds which may be employed in the present invention include chalcogen anion deficient variants of the compounds of any of the formulae defined herein, and in particular chalcogen anion deficient variants of the compounds of formulae II or IIA-IIE above. A chalcogen anion deficient variant of a compound as defined herein is a variant of the defined compound which has greater than 0% chalcogen anion vacancies. A chalcogen anion deficient variant of a compound as defined herein is typically a variant of the defined compound which has greater than 0% and up to 10% chalcogen anion vacancies, for instance greater than 0% and less than 5% chalcogen anion vacancies, or greater than 0% and up to 1% chalcogen anion vacancies.

In another embodiment, the compound is a Dion-Jacobson phase. Thus, typically, the compound is a compound of Formula III:

[A⁴⁺]₂[A²⁺]_{2q-2}[Bⁿ⁺]_{q}[B^{m+}]_{q}[X]_{6q+2} (III);

wherein: q is an integer from 1 to 5 inclusive; [A⁴⁺] is one or more tetracations, as defined herein; [A²⁺] is one or more dications; [Bⁿ⁺] is the one or more first B cations; [B^{m+}] is the one or more second B cations; and [X] is the one or more chalcogen anions; wherein n represents the oxidation state of the first B cation and is 1 or 2; m represents the oxidation state of the second B cation and is 6 or 7; and n + m is equal to 8.

In one embodiment, the compound of Formula III is a compound of Formula IIIA:

A⁴⁺₂A²⁺_{2q-2}Bⁿ⁺_{q}B^{m+}_{q}X_{6q+2} (IIIA)

wherein: q is an integer from 1 to 5 inclusive; A⁴⁺ an A tetracation, as defined herein; A²⁺ is an A dications, as defined herein; Bⁿ⁺ is a first B cations, as defined herein; B^{m+} is a second B cations, as defined herein; and X is a chalcogen anion, as defined herein; wherein n represents the oxidation state of the first B cation and is 1 or 2; m represents the oxidation state of the second B cation and is 6 or 7; and n + m is equal to 8.

For instance, the compound may be a compound of Formula IIIA selected from Zr₂AgIO₈, Hf₂AgIO₈, Sn₂AgIO₈, Zr₂Ba₂Ag₂I₂O₁₄, Hf₂Ba₂Ag₂I₂O₁₄ and Sn₂Ba₂Ag₂I₂O₁₄.

The compound according to Formula III may be a compound of Formula IIIB, IIIC, IIID, IIIE or IIIF:

[(A¹)⁴⁺ₓ(A²)⁴⁺₁₋ₓ]₂A²⁺_{2q-2}Bⁿ⁺_{q}B^{m+}_{q}X_{6q+2} (IIIB),

A⁴⁺₂[(A¹)²⁺ₓ(A²)²⁺₁₋ₓ]_{2q-2}Bⁿ⁺_{q}B^{m+}_{q}X_{6q+2} (IIIC),

A⁴⁺₂A²⁺_{2q-2}[(B¹)ⁿ⁺ₓ(B²)ⁿ⁺₁₋ₓ]_{q}B^{m+}_{q}X_{6q+2} (IIID),

A⁴⁺₂A²⁺_{2q-2}Bⁿ⁺q[(B¹)^{m+}ₓ(B²)^{m+}₁₋ₓ]_{q}X_{6q+2} (IIIE),

A⁴⁺₂A²⁺_{2q-2}Bⁿ⁺_{q}B^{m+}_{q}[X¹ₓX²₁₋ₓ]_{6q+2} (IIIF),

wherein: q is an integer from 1 to 5 inclusive; (A¹)⁴⁺ and (A²)⁴⁺ represent two different A tetracations; (A²)²⁺ and (A²)²⁺ represent two different A dications, as defined herein; (B¹)ⁿ⁺ and (B²)ⁿ⁺ represent two different first B cations, Bⁿ⁺, as defined herein; (B¹)^{m+} and (B²)^{m+} represent two different second B cations, B^{m+}, as defined herein; X¹ and X² represent two different chalcogen anions, X, as defined herein; wherein n represents the oxidation state of the first B cation and is 1 or 2; m represents the oxidation state of the second B cation and is 6 or 7; and n + m is equal to 8; and wherein x is greater than 0 and less than 1, typically where x is between 0.05 and 0.95.

In formulae III, IIIA, IIIB, IIIC, IIID, IIIEand IIIF q may be from 1 to 4 inclusive, or from 1 to 3 inclusive. For instance, q may be an integer selected from 1, 2, 3, 4 or 5, typically 1, 2 or 3.

The compound of formula III or IIIA-IIIF may comprise vacancies at the chalcogen anion X sites. For instance, when X comprises O²⁻,the compound of formula III or IIIA-IIIF may comprise oxide anion vacancies. Therefore, the stoichiometry for the one or more chalcogen anions, X, may be slightly less than that the ideal stoichiometry given in formula III or IIIA-IIIF above. As the skilled person would understand, a deficiency in chalcogen anions means that fewer positive charges are required to balance the negative charges of the chalcogen anions. Thus, charge neutrality may by maintained by a portion of the cations in the compound being in a lower oxidation state, and therefore having a lower positive charge, than would otherwise be the case. Additionally or alternatively, charge neutrality may be maintained by a deficiency in cations, e.g. by corresponding cation vacancies, or by replacing a small number of the B-site cations with cations of a lower oxidation state, for instance replacing I⁷⁺ with Sb⁵⁺. Accordingly, compounds which may be employed in the present invention include chalcogen anion deficient variants of the compounds of any of the formulae defined herein, and in particular chalcogen anion deficient variants of the compounds of formulae III or IIIA-IIIF above. A chalcogen anion deficient variant of a compound as defined herein is a variant of the defined compound which has greater than 0% chalcogen anion vacancies. A chalcogen anion deficient variant of a compound as defined herein is typically a variant of the defined compound which has greater than 0% and up to 10% chalcogen anion vacancies, for instance greater than 0% and less than 5% chalcogen anion vacancies, or greater than 0% and up to 1% chalcogen anion vacancies.

In one embodiment, the compound is a compound of Formula IV:

[A']₄[A²⁺]₂ᵣ[Bⁿ⁺]ᵣ[B^{m+}]ᵣ[X]₆ᵣ₊₂ (IV);

wherein: r is an integer from 1 to 5 inclusive; [A⁺] is one or more monocations, as defined herein; [A²⁺] is one or more dications, as defined herein; [Bⁿ⁺] is the one or more first B cations, as defined herein; [B^{m+}] is the one or more second B cations, as defined herein; and [X] is the one or more chalcogen anions, as defined herein; wherein n represents the oxidation state of the first B cation and is 1 or 2; m represents the oxidation state of the second B cation and is 6 or 7; and n + m is equal to 8.

In one embodiment, the compound of Formula IV is a compound of Formula IVA:

A⁺₄A²⁺₂ᵣBⁿ⁺ᵣB^{m+}ᵣX₆ᵣ₊₂ (IVA);

Wherein: A⁺ is an A monocation, as defined herein; A²⁺ is an A dication, as defined herein; Bⁿ⁺ is a first B cation, as defined herein; B^{m+} is a second B cation, as defined herein; and X is the a chalcogen anions, as defined herein; wherein n represents the oxidation state of the first B cation and is 1 or 2; m represents the oxidation state of the second B cation and is 6 or 7; and n + m is equal to 8.

For instance, the compound of Formula IVA may be selected from Cs₄Ba₂AgIO₈, Rb₄Ba₂AgIO₈, [CH₃NH₃]₄Ba₂AgIO₈ or [H₂N-C(H)=NH₂]₄Ba₂AgIO₈. Typically, the compound is Cs₄Ba₂AgIO₈.

The compound according to Formula IV may be a compound of Formula IVB, IVC, IVD, IVE or IVF:

[(A¹)⁺ₓ(A²)⁺₁₋ₓ]₄A²⁺₂ᵣBⁿ⁺ᵣB^{m+}ᵣX₆ᵣ₊₂ (IVB);

A⁺₄[(A¹)²⁺ₓ(A²)²⁺₁₋ₓ] ₂rBⁿ⁺ᵣB^{m+}ᵣX₆ᵣ₊₂ (IVC);

A⁺₄A²⁺₂ᵣ[(B¹)ⁿ⁺x(B²)ⁿ⁺₁₋ₓ]ᵣB^{m+}ᵣX₆ᵣ₊₂ (IVD);

A⁺₄A²⁺₂Bⁿ⁺ᵣ[(B¹)^{m+}ₓ(B²)^{m+}₁₋ₓ]ᵣX₆ᵣ₊₂ (IVE);

A⁺₄A ²⁺₂ᵣBⁿ⁺ᵣB^{m+}ᵣ[X¹ₓX²₁₋ₓ]₆ᵣ₊₂ (IVF);

wherein: r is an integer from 1 to 5 inclusive; (A¹)⁺ and (A²)⁺ represent two different A monocations; (A²)²⁺ and (A²)²⁺ represent two different A dications, as defined herein; (B¹)ⁿ⁺ and (B²)ⁿ⁺ represent two different first B cations, Bⁿ⁺, as defined herein; (B¹)^{m+} and (B²)^{m+} represent two different second B cations, B^{m+}, as defined herein; X¹ and X² represent two different chalcogen anions, X, as defined herein; wherein n represents the oxidation state of the first B cation and is 1 or 2; m represents the oxidation state of the second B cation and is 6 or 7; and n + m is equal to 8; and wherein x is greater than 0 and less than 1, typically where x is between 0.05 and 0.95.

The compound of formula IV or IVA-IVF may comprise vacancies at the chalcogen anion X sites. For instance, when X comprises O²⁻,the compound of formula IV or IIIA-IVF may comprise oxide anion vacancies. Therefore, the stoichiometry for the one or more chalcogen anions, X, may be slightly less than that the ideal stoichiometry given in formula IV or IVA-IVF above. As the skilled person would understand, a deficiency in chalcogen anions means that fewer positive charges are required to balance the negative charges of the chalcogen anions. Thus, charge neutrality may by maintained by a portion of the cations in the compound being in a lower oxidation state, and therefore having a lower positive charge, than would otherwise be the case. Additionally or alternatively, charge neutrality may be maintained by a deficiency in cations, e.g. by corresponding cation vacancies, or by replacing a small number of the B-site cations with cations of a lower oxidation state, for instance replacing I⁷⁺ with Sb⁵⁺. Accordingly, compounds which may be employed in the present invention include chalcogen anion deficient variants of the compounds of any of the formulae defined herein, and in particular chalcogen anion deficient variants of the compounds of formulae IV or IVA-IVF above. A chalcogen anion deficient variant of a compound as defined herein is a variant of the defined compound which has greater than 0% chalcogen anion vacancies. A chalcogen anion deficient variant of a compound as defined herein is typically a variant of the defined compound which has greater than 0% and up to 10% chalcogen anion vacancies, for instance greater than 0% and less than 5% chalcogen anion vacancies, or greater than 0% and up to 1% chalcogen anion vacancies.

In formulae IV, IVA, IVB, IVC, IVD, IVE and IVF r may be from 1 to 4 inclusive, or from 1 to 3 inclusive. For instance, r may be an integer selected from 1, 2, 3, 4 or 5, typically 1, 2 or 3.

### Semiconductor device

The present invention also provides a semiconductor device comprising an semiconducting material, wherein the semiconducting material comprises a compound comprising:
(v) one or more cations, A, as defined herein;
(vi) one or more first B cations, Bⁿ⁺, at least one of which is Ag⁺, as defined herein;
(vii) one or more second B cations, B^{m+}, at least one of which is a heptacation, B⁷⁺, as defined herein; and
(viii) one or more chalcogen anions, X, as defined herein;
wherein the one or more first B cations, Bⁿ⁺ are different from the one or more second B cations, B^{m+}; n represents the oxidation state of the first B cation and is a positive integer of from 1 to 7 inclusive; m represents the oxidation state of the second B cation and is a positive integer of from 1 to 7 inclusive; and n + m = 8.

Hence, the compound in the semiconductor device may be a compound as defined herein, for instance the compound as defined for the optoelectronic material of the present invention, the compound of the present invention or the compound as defined for the photocatalyst of the present invention.

The semiconductor device may be an optoelectronic device (for instance a photovoltaic device, a solar cell, a photodetector, a photomultiplier, a photoresistor, a charge injection laser, a photodiode, a photosensor, a chromogenic device, a light-sensitive transistor, a phototransistor, a light-emitting device, an electroluminescent device, or a light-emitting diode), a transistor, a solid state triode, a battery, a battery electrode, a capacitor or a super-capacitor.

The semiconductor device is typically a transistor or an optoelectronic device. Typically, the semiconductor device is an optoelectronic device, for instance an optoelectronic device selected from a photovoltaic device, a light emitting device (for instance an electroluminescent device, for example a light emitting diode) or a photodetector.

The semiconducting material may comprise greater than or equal to 50 wt% of the compound, as defined herein. The semiconducting material may comprise additional components. In particular, the semiconducting material may comprise one or more dopant compounds. Typically, the semiconducting material comprises greater than or equal to 80 wt% of the compound, as defined herein. Preferably, the semiconducting material comprises greater than or equal to 95 wt% of the compound as defined herein, for instance greater than or equal to 99 wt% of the compound as defined herein. The semiconducting material may consist, or consist essentially, of the compound.

The semiconducting material is typically solid. Typically, the semiconducting material comprises crystalline material. The semiconducting material may be crystalline or polycrystalline. For instance, the semiconducting material may comprise a plurality of crystallites of the compound.

The semiconducting material may be in any form. Typically the semiconducting material is in the form of a layer, for instance a photoactive, photoemissive or photoabsorbent, material in the form of a layer. The semiconducting material typically comprises a layer of the compound, as defined herein. The semiconducting material may consist essentially of a layer of the compound, as defined herein. The semiconductor device may comprise a layer of said semiconducting material (for instance a photoactive material) having a thickness of greater than or equal to 50 nm, or having a thickness of greater than or equal to 100 nm.

Typically, the semiconductor device comprises a layer of the semiconducting material, which layer preferably has a thickness of from 5 nm to 1000 nm. Preferably, the layer of the semiconducting material has a thickness of from 100 nm to 700 nm, for instance from 200 nm to 500 nm. The layer of the semiconducting material may consist, or consist essentially of a layer of the compound having a thickness of from 100 nm to 700 nm. For instance, the semiconductor device may comprise a layer of said semiconducting material, which semiconducting material comprises a compound as defined herein, which layer has a thickness of greater than or equal to 100 nm. In some devices, the layer may be a thin sensitising layer, for instance having a thickness of from 5 nm to 50 nm. In devices wherein the layer of said semiconducting material forms a planar heterojunction with an n-type or p-type region, the layer of said photoactive material may have a thickness of greater than or equal to 100 nm. Preferably, the layer of said photoactive material has a thickness of from 100 nm to 700 nm, for instance from 200 nm to 500 nm. The term "planar heterojunction", as used herein, means that surface defining junction between the semiconducting material and the n- or p-type region is substantially planar and has a low roughness, for instance a root mean squared roughness of less than 20 nm over an area of 25 nm by 25 nm, for instance a root mean squared roughness of less than 10 nm, or less than 5 nm, over an area of 25 nm by 25 nm.

The semiconducting material often acts as a photoactive component (e.g. a photoabsorbent component or a photoemissive component) within the semiconductor device. The semiconducting material may alternatively act as a p-type semiconductor component, an n-type semiconductor component, or an intrinsic semiconductor component in the semiconductor device. For instance, the semiconducting material may form a layer of a p-type, n-type or intrinsic semiconductor in a transistor, e.g. a field effect transistor. For instance, the semiconducting material may form a layer of a p-type or n-type semiconductor in an optoelectronic device, e.g. a solar cell or an LED.

Typically, which semiconductor device comprises:
an n-type region comprising at least one n-type layer;
a p-type region comprising at least one p-type layer; and, disposed between the n-type region and the p-type region:
   a layer of the semiconducting material.

For instance, the semiconductor device is often an optoelectronic device, which optoelectronic device comprises:
an n-type region comprising at least one n-type layer;
a p-type region comprising at least one p-type layer; and, disposed between the n-type region and the p-type region:
said layer of a semiconducting material which comprises (or consists essentially of) a layer of said compound, as defined herein. An n-type layer is typically a layer of an n-type semiconductor. A p-type layer is typically a layer of a p-type semiconductor.

The n-type region comprises at least one n-type layer. The n-type region may comprise an n-type layer and an n-type exciton blocking layer. Such an n-type exciton blocking layer is typically disposed between the n-type layer and the layer(s) comprising the semiconducting material. The n-type region may have a thickness of from 50 nm to 1000 nm. For instance, the n-type region may have a thickness of from 50 nm to 500 nm, or from 100 nm to 500 nm.

Preferably, the n-type region comprises a compact layer of an n-type semiconductor.

The n-type semiconductor may be selected from a metal oxide, a metal sulphide, a metal selenide, a metal telluride, a perovskite, amorphous Si, an n-type group IV semiconductor, an n-type group III-V semiconductor, an n-type group II-VI semiconductor, an n-type group I-VII semiconductor, an n-type group IV-VI semiconductor, an n-type group V-VI semiconductor, and an n-type group II-V semiconductor, any of which may be doped or undoped. Typically, the n-type 46emiconductor is selected from a metal oxide, a metal sulphide, a metal selenide, and a metal telluride. For instance, the n-type region may comprise an inorganic material selected from oxide of titanium, tin, zinc, niobium, tantalum, tungsten, indium, gallium, neodymium, palladium, or cadmium, or an oxide of a mixture of two or more of said metals. For instance, the n-type layer may comprise TiO₂, SnO₂, ZnO, SnO, Nb₂O₅, Ta₂O₅, WO₃, W₂O₅, In₂O₃, Ga₂O₃, Nd₂O₃, PbO, or CdO. The n-type region may comprise an organic electron transporting materials, for instance C₆₀, Phenyl-C61-butyric acid methyl ester (PCBM), Bis-PCBM, or 3,9-bis(2-methylene-(3-(1,1-dicyanomethylene)-indanone))-5,5,11,11-tetrakis(4-hexylphenyl)-dithieno[2,3-d:2',3'-d']-s-indaceno[1,2-b:5,6-b']dithiophene. The n-type region may comprise an inorganic/organic bilayer such as a TiO₂/ fullerene bilayer, SnO/fullerene bilayer or a ZnO/ fullerene bilayer. Typically, the n-type region comprises SnO₂ or TiO₂, for instance a compact layer of TiO₂ or SnO₂. Often, the n-type region also comprises a layer of a fullerene or a fullerene derivative (for instance C₆₀ or Phenyl-C61-butyric acid methyl ester (PCBM)).

Typically, the n-type region comprises TiO₂, SnO₂, ZnO, SnO, C₆₀, PCBM, Bis-PCBM, 3,9-bis(2-methylene-(3-(1,1-dicyanomethylene)-indanone))-5,5,11,11-tetrakis(4-hexylphenyl)-dithieno[2,3-d:2',3'-d']-s-indaceno[1,2-b:5,6-b']dithiophene, or an inorganic/organic bilayer such as a TiO₂/ fullerene bilayer, SnO/fullerene bilayer or a ZnO/fullerene bilayer.

Preferably, the p-type region comprises a compact layer of a p-type semiconductor.

Suitable p-type semiconductors may be selected from polymeric or molecular hole transporters. The p-type layer employed in the semiconductor device of the invention may for instance comprise spiro-OMeTAD (2,2',7,7'-tetrakis-(N,N-di-p-methoxyphenylamine)9,9'-spirobifluorene)), P3HT (poly(3-hexylthiophene)), PCPDTBT (Poly[2,1,3-benzothiadiazole-4,7-diyl[4,4-bis(2-ethylhexyl)-4H-cyclopenta[2,1-b:3,4-b']dithiophene-2,6-diyl]]), PVK (poly(N-vinylcarbazole)), HTM-TFSI (1-hexyl-3-methylimidazolium bis(trifluoromethylsulfonyl)imide), Li-TFSI (lithium bis(trifluoromethanesulfonyl)imide), tetracene, MeO-TPD (N,N,N',N'-Tetrakis(4-methoxyphenyl)benzidine), poly-TPD (Poly[N,N'-bis(4-butylphenyl)-N,N'-bisphenylbenzidine]), PTAA (Poly[bis(4-phenyl)(2,4,6-trimethylphenyl)amine]) or tBP (tert-butylpyridine). The p-type region may comprise carbon nanotubes. Usually, the p-type material is selected from spiro-OMeTAD, P3HT, PCPDTBT and PVK. Preferably, the p-type layer employed in the optoelectronic device of the invention comprises spiro-OMeTAD.

In some embodiments, the p-type layer may comprise an inorganic hole transporter. For instance, the p-type layer may comprise an inorganic hole transporter comprising an oxide of nickel, vanadium, copper or molybdenum; Ga₂O₃, CuSCN, NiO, Cul, CuBr, CuSCN, Cu₂O, CuO or CIS; a perovskite; amorphous Si; a p-type group IV semiconductor, a p-type group III-V semiconductor, a p-type group II-VI semiconductor, a p-type group I-VII semiconductor, a p-type group IV-VI semiconductor, a p-type group V-VI semiconductor, and a p-type group II-V semiconductor, which inorganic material may be doped or undoped. The p-type layer may be a compact layer of said inorganic hole transporter.

Typically, the p-type layer comprises a p-type material selected from NiO, Ga2O3, CuSCN, CuI, and CuO, spiro-OMeTAD, MeO-TPD, Tetracene, P3HT, Poly-TPD, or PTAA.

The layer of the semiconducting material typically forms a planar heterojunction with the n-type region or the p-type region. The layer of the semiconducting material typically forms a first planar heterojunction with the n-type region and a second planar heterojunction with the p-type region. This forms a planar heterojunction device. The term "planar heterojunction" as used herein refers to a junction between two regions where one region does not infiltrate the other. This does not require that the junction is completely smooth, just that one region does not substantially infiltrate pores in the other region.

The semiconductor device typically further comprises one or more first electrodes and one or more second electrodes. The one or more first electrodes are typically in contact with the n-type region, if such a region is present. The one or more second electrodes are typically in contact with the p-type region, if such a region is present. Typically: the one or more first electrodes are in contact with the n-type region and the one or more second electrodes are in contact with the p-type region; or the one or more first electrodes are in contact with the p-type region and the one or more second electrodes are in contact with the n-type region.

The first and second electrode may comprise any suitable electrically conductive material. The first electrode typically comprises a transparent conducting oxide. The second electrode typically comprises one or more metals. The second electrode may alternatively comprise graphite. Typically, the first electrode typically comprises a transparent conducting oxide and the second electrode typically comprises one or more metals.

The transparent conducting oxide typically comprises fluorine-doped tin oxide (FTO), indium tin oxide (ITO) or aluminium-doped zinc oxide (AZO), and typically ITO. The second electrode typically comprises a metal selected from silver, gold, copper, aluminium, platinum, palladium, or tungsten. Each electrode may form a single layer or may be patterned.

The semiconductor device (for instance a photovoltaic device, or a light emitting device) may comprise the following layers in the following order:
I. one or more first electrodes as defined herein;
II. an n-type region comprising at least one n-type layer as defined herein;
III. a layer of the semiconducting material comprising the crystalline compound as defined herein;
IV. a p-type region comprising at least one p-type layer as defined herein; and
V. one or more second electrodes as defined herein.

The semiconductor device (for instance a photovoltaic device, or a light emitting device) may comprise the following layers in the following order:
I. one or more first electrodes which comprise a transparent conducting oxide, preferably FTO;
II. an n-type region comprising at least one n-type layer as defined herein;
III. a layer of the semiconducting material as defined herein;
IV. a p-type region comprising at least one p-type layer as defined herein; and
V. one or more second electrodes which comprise a metal, preferably silver or gold.

The one or more first electrodes may have a thickness of from 100 nm to 700 nm, for instance of from 100 nm to 400 nm. The one or more second electrodes may have a thickness of from 10 nm to 500 nm, for instance from 50 nm to 200 nm or from 10 nm to 50 nm. The n-type region may have a thickness of from 50 nm to 500 nm. The p-type region may have a thickness of from 50 nm to 500 nm.

### Photoluminescent material

Also disclosed herein are photoluminescent materials comprising a compound as defined herein, for instance the compound as defined for the optoelectronic material of the present invention, the compound of the present invention, the compound as defined for the photocatalyst of the present invention or the compound as defined in the semiconducting material in the semiconductor device of the present invention.

### Electronic material

The invention also provides an electronic material comprising a compound as defined herein, for instance the compound as defined for the optoelectronic material of the present invention, the compound of the present invention, the compound as defined for the photocatalyst of the present invention or the compound as defined in the semiconducting material in the semiconductor device of the present invention.

### Process

The invention also provides a process for producing a compound, as defined herein. The invention therefore provides a process for producing a compound comprising
(v) one or more cations, A, as defined herein;
(vi) one or more first B cations, Bⁿ⁺, at least one of which is Ag⁺, as defined herein;
(vii) one or more second B cations, B^{m+}, at least one of which is a heptacation, B⁷⁺, as defined herein; and
(viii) one or more chalcogen anions, X, as defined herein;

wherein the one or more first B cations, Bⁿ⁺ are different from the one or more second B cations, B^{m+}; n represents the oxidation state of the first B cation and is a positive integer of from 1 to 7 inclusive; m represents the oxidation state of the second B cation and is a positive integer of from 1 to 7 inclusive; and n + m = 8;
said process comprising treating a precursor compound comprising the one or more first B cations, Bⁿ⁺, and the one or more second B cations, B^{m+}, with a composition comprising the one or more cations, A, to obtain the compound,
wherein the precursor compound is a solid, which process comprises dissolving the solid precursor compound comprising the one or more first B cations, Bⁿ⁺ , and the one or more second B cations, B^{m+}, in a solvent to obtain a solution comprising the one or more first B cations Bⁿ⁺ , and the one or more second B cations, B^{m+}, and contacting the solution with the composition comprising the one or more cations, A, to obtain the compound.

The compound may be a compound as defined herein, for instance the compound as defined for the optoelectronic material of the present invention, the compound of the present invention, the compound as defined for the photocatalyst of the present invention or the compound as defined in the semiconducting material in the semiconductor device of the present invention.

The inventors have found that it is critical to synthesize the precursor compound first, prior to treating the precursor compound with the composition the one or more cations, A. The inventors have found that the methods described in the prior art, in which solutions comprising all the B and A cations are simply mixed do not yield the desired compound. Instead, typically, the precursor compound, for example a compound according to Formula V below, is formed rather than the desired product. The inventors have surprisingly found that the process in which this compound is formed first, then treated with the one or more cations, A, provides the desired compound as the product.

The solvent is usually a polar solvent, typically a polar aprotic solvent. For instance, the solvent may be dimethylformamide, acetonitrile, dimethylsulfoxide and N-methyl-2-pyrrolidone.

Typically, the precursor compound or the composition comprising the one or more cations, A, comprise the one or more chalcogen anions, X. The precursor compound and the composition comprising the one or more cations, A, may both comprise the one or more chalcogen anions, X.

The one or more chalcogen anions, X, may be present as counter anions to the one or more first B cations, Bⁿ⁺, or the one or more second B cations, B^{m+}. The one or more chalcogen anions, X, may be present as counter anions to the one or more first B cations, Bⁿ⁺, and the one or more second B cations, B^{m+}. The one or more chalcogen anions, X, may be present as counter anions to the one or more cations, A.

Typically, the precursor compound is a precursor compound of Formula V:

[Bⁿ⁺][B^{m+}][X]₄ (V);

wherein: [Bⁿ⁺] is the one or more first B cations, as defined herein; [B^{m+}] is the one or more second B cations, as defined herein; and [X] is one or more chalcogen anions, as defined herein; wherein n represents the oxidation state of the first B cation and is a positive integer of from 1 to 7 inclusive; m represents the oxidation state of the second B cation and is a positive integer of from 1 to 7 inclusive; and n + m is equal to 8

In the present invention, at least one of the one or more first B cations, Bⁿ⁺, is Ag⁺. Typically, the one or more first B cations, Bⁿ⁺, additionally comprises one or more monocations, typically one or more inorganic monocations, typically one or more metal monocations. Typically, the one or more first B cations, Bⁿ⁺, comprise noble metal cations and/or alkali metal cations. Noble metals are typically selected from ruthenium, rhodium, palladium, silver, osmium, iridium, platinum, gold, mercury, rhenium and copper. Alkali metals are those metals of group 1 of the periodic table, including lithium, sodium, potassium, rubidium, caesium and francium. Typically, the one or more first B cations, Bⁿ⁺ additionally comprise one or more of Li⁺, Na⁺, K⁺, Rb⁺, Cs⁺, Cu⁺, Au⁺ and Hg⁺.

At least one of the one or more second B cations, B^{m+}, is a heptacation, B⁷⁺. Typically, the one or more second B cations, B^{m+}, comprise one or more halogen cations in the +7 oxidation state. Halogens are those elements of group 17 of the periodic table, and include fluorine, chlorine, bromine, iodine and astatine. Typically, the one or more second B cations, B^{m+}, comprise one or more halogen cations in the +7 oxidation state selected from chlorine, bromine and iodine, typically bromine or iodine. Preferably, the one or more second B cations, B^{m+}, comprise iodine as I⁷⁺.

Typically, the one or more first B cations, Bⁿ⁺, comprise Ag⁺ and the one or more second B cations, B^{m+}, comprise I⁷⁺. Thus, the compound may comprise a single first B cation which is Ag⁺, and a single second B cation which is I⁷⁺. The compound may comprise multiple first B cations, Bⁿ⁺, and multiple second B cations, B^{m+}, wherein the multiple first B cations, Bⁿ⁺, comprise Ag⁺, and the multiple second B cations, B^{m+}, comprise I⁷⁺.

Therefore, the precursor compound of Formula V may be AgIO₄.

The process may further comprise evaporating a solution comprising the one or more first B cations, Bⁿ⁺, and the one or more second B cations, B^{m+}, to obtain the precursor compound. The solution may comprise one or more chalcogen anions, X.

The evaporation may be performed by allowing the solution comprising the one or more first B cations, Bⁿ⁺, and the one or more second B cations, B^{m+}, to dry in air. Alternatively, the solution comprising the one or more first B cations, Bⁿ⁺, and the one or more second B cations, B^{m+}, may be heated to evaporate the solvent. For instance, the solution comprising the one or more first B cations, Bⁿ⁺, and the one or more second B cations, B^{m+}, may be heated to a temperature between 40°C and 200°C, typically between 60°C and 180°C, between 100°C and 150°C, for instance at 120°C.

The solution comprising the one or more first B cations, Bⁿ⁺, and the one or more second B cations, B^{m+}, is typically prepared by dissolving a compound comprising the one or more first B cations, Bⁿ⁺, and a compound comprising the one or more second B cations, B^{m+}, in a solvent. Typically, the solvent is a polar solvent, for instance a polar protic solvent. The solvent may therefore be water.

The compound comprising the one or more first B cations, Bⁿ⁺, typically comprises one or more counter anions. The one or more counter anions may be one or more chalcogen anions, X, as defined herein, or any other suitable counter anion. For instance, the compound comprising the one or more first B cations, Bⁿ⁺ may be an oxide, sulphide or selenide of Bⁿ⁺, for instance an oxide, sulphide or selenide of Ag⁺. For instance the compound comprising the one or more first B cations, Bⁿ⁺, may be silver oxide (Ag₂O).

The compound comprising the one or more second B cations, B^{m+}, typically comprises one or more counter anions. The one or more counter anions may be one or more chalcogen anions, X, as defined herein, or any other suitable counter anion. For instance, the compound comprising the one or more second B cations, B^{m+}, may be an oxide, sulphide or selenide of B^{m+}. In one embodiment, the compound comprising the one or more second B cations, B^{m+}, comprises an oxo-anion of the one or more second B cations, B^{m+}. When m is 7, the compound comprising one or more second B cations, B^{m+}, may comprise an oxo-anion of formula [B^{m+}O₄]⁻, for instance a periodate ion ([IO₄]⁻), perbromate ion ([BrO₄]⁻) or a perchlorate ion ([ClO₄]⁻). For instance the compound comprising the one or more first B cations, B^{m+}, may be periodic acid (HIO₄/H₅IO₆). For instance, the solution comprising the one or more first B cations, Bⁿ⁺, and the one or more second B cations, B^{m+}, may be prepared by dissolving Ag₂O and H₅IO₆ in water.

Typically, the composition comprising the one or more cations, A, is a solution comprising the one or more cations, A. The solution may be produced by dissolving a compound comprising the one or more cations, A, in a solvent. Typically, the solvent is a polar solvent, for instance a polar protic solvent such as water, or a polar aprotic solvent such as dimethylformamide, acetonitrile, dimethylsulfoxide, and N-methyl-2-pyrrolidone.

The compound comprising the one or more cations, A, usually comprises one or more counter anions. The one or more counter anions may be one or more chalcogen anions, X, as defined herein, or any other suitable counter anion.

Many such counter anions are known to the skilled person. For instance, the one or more counter anions to the A, Bⁿ⁺ or B^{m+} cations may be selected from inorganic anions, for instance halide anions, hydroxide anions, thiocyanate anions (SCN⁻), sulfate anions (SO₄²⁻), phosphate anions (PO₄³⁻), carbonate anions (CO₃²⁻), tetrafluoroborate anions (BF₄⁻), or organic anions. Organic anions include carboxylate anions, such as formate or acetate.

The process comprises dissolving the solid precursor compound comprising the one or more first B cations, Bⁿ⁺ , and the one or more second B cations, B^{m+}, in a solvent to obtain a solution comprising the one or more first B cations Bⁿ⁺ , and the one or more second B cations, B^{m+}, and contacting the solution with a solution comprising the one or more cations, A, to obtain the compound. Typically, when the solution comprising the one or more first B cations, Bⁿ⁺ , and the one or more second B cations, B^{m+}, contacts the solution comprising the one or more cations, A, the compound forms as a precipitate or dispersion.

Typically, the process comprises recovering the compound. Typically, recovering the compound comprises a solvent removal step. The solvent removal step may involve heating the mixture of when the solution comprising the one or more first B cations, Bⁿ⁺ , the one or more second B cations, B^{m+}, and the one or more cations, A. The heating is typically at a temperature of from 40°C and 200°C, typically between 60°C and 140°C, between 75°C and 125°C, for instance at 100°C.

The process may comprise further steps of washing the compound with a solvent, typically a polar solvent, for instance a polar aprotic solvent such as acetonitrile or a polar protic solvent such as ethanol. The process may further comprise drying the compound. The compound may be dried by allowing the compound to dry in air. Alternatively, the compound may be heated to evaporate any residual solvent. For instance, the compound may be heated to a temperature between 30°C and 200°C, typically between 40°C and 150°C, between 50°C and 100°C, for instance at about 70°C.

### Use of the compound

A compound as defined herein may be used as an optoelectronic material, for instance as a photovoltaic material or as an electroluminescent material.

A compound as defined herein may be used as a photoluminescent material.

A compound as defined herein may be used as a photocatalyst.

A compound as defined herein may be used as an electronic material.

A compound as defined herein may be used as a semiconductor.

The compound may be any compound as defined herein, for instance the compound as defined for the optoelectronic material of the present invention, the compound of the present invention, the compound as defined for the photocatalyst of the present invention or the compound as defined in the semiconducting material in the semiconductor device of the present invention.

### EXAMPLES

The advantages of the invention will hereafter be described with reference to some specific examples.

### Computational methods

All calculations were performed within the density functional theory (DFT). Structural relaxations were performed using PBE exchange-correlation functional (Perdew, J. P.; Burke, K.; Ernzerhof, M. Generalized Gradient Approximation Made Simple. Phys. Rev. Lett. 1996, 77, 3865), employing the Projected Augmented Wave method (PAW - Blochl, P. E. Projector Augmented-Wave Method. Phys. Rev. B 1994, 50, 17953-17979) as implemented in the VASP code (Kresse, G.; Furthmuller, J. Efficient Iterative Schemes For ab initio Total-Energy Calculations Using a Plane-Wave Basis Set. Phys. Rev. B 1996, 54, 11169-11186). The kinetic cutoff energy for the wavefunctions was set at 450 eV, and Γ-centered k-point grid of at least 8 × 8 × 8 was used to sample the Brillouin zone. The convergence threshold for the forces was set at 0.005 eV/A², and 10⁻⁸ eV for the electronic total energy. Electronic band structures were calculated using a PBE functional 1 (DFT-PBE), using the same parameters as the structural relaxation runs. To improve the description of the band gap, we also employed PBE0 hybrid functional calculations (DFT-PBE0 - Paier, J.; Hirschl, R.; Marsman, M.; Kresse, G. The Perdew-Burke-Ernzerhof Exchange-Correlation Functional Applied to the G2-1 Test Set Using a Plane-Wave Basis Set. J. Chem. Phys. 2005, 122, 234102), using a coarser 6×6×6 Γ-centered k-grid. We subsequently rigidly shifted the PBE band structures to match the gap calculated with the hybrid functional. To calculate the squared wavefunctions we used the Quantum-espresso suite (Giannozzi, P et al. QUANTUM ESPRESSO: A Modular and Open-Source Software Project for Quantum Simulations of Materials. J. Phys.: Condens. Matter. 2009, 21, 395502.), norm-conserving pseudopotentials (Troullier, N.; Martins, J. L. Efficient Pseudopotentials for Plane-Wave Calculations. Phys. Rev. B 1991, 43, 1993), within DFT-PBE, and plotted these using VESTA software (Momma, K.; Izumi, F. VESTA: A Three-Dimensional Visualization System for Electronic and Structural Analysis. J. Appl. Cryst. 2008, 41, 653.). The effective masses were calculated using finite differences within DFT-PBE using small increments of 0.01(2π/a, with a the lattice constant of the unit cell), and including spin-orbit coupling effects.

### Synthesis of Ba₂AgIO₆

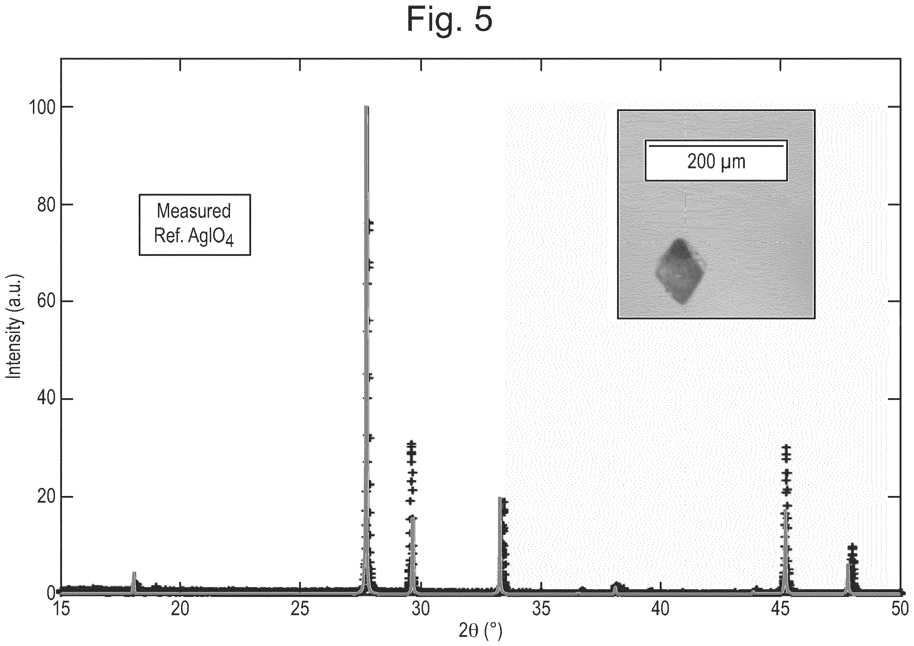

We fully dissolved 25 mM of Ag₂O (Sigma-Aldrich, 99%) and 50 mM of H₅IO₆ (Sigma-Aldrich, 99%) in 3 mL of water and 1 mL nitric acid in a sonicator bath. We subsequently transferred the solution to a petri-dish and heated at 120°C until all of the solution was dried out. At this point we identified the formation of yellow AgIO₄ crystals - see Figure 5. We dissolved 30 mM of AgIO₄ in 3 mL of acetonitrile, and 60 mM of Ba(OH)₂ in 5 mL of water by sonication for a few minutes in the sonicator bath. We injected the solution of AgIO₄ into the Ba(OH)₂ solution at 20°C, and a brown precipitate immediately formed inside the mixed solution. We finally heated the dispersion at 100°C for 2 h in a box oven, washed the products with acetonitrile and EtOH, and dried at 70°C for 2 h.

### Comparative synthesis example

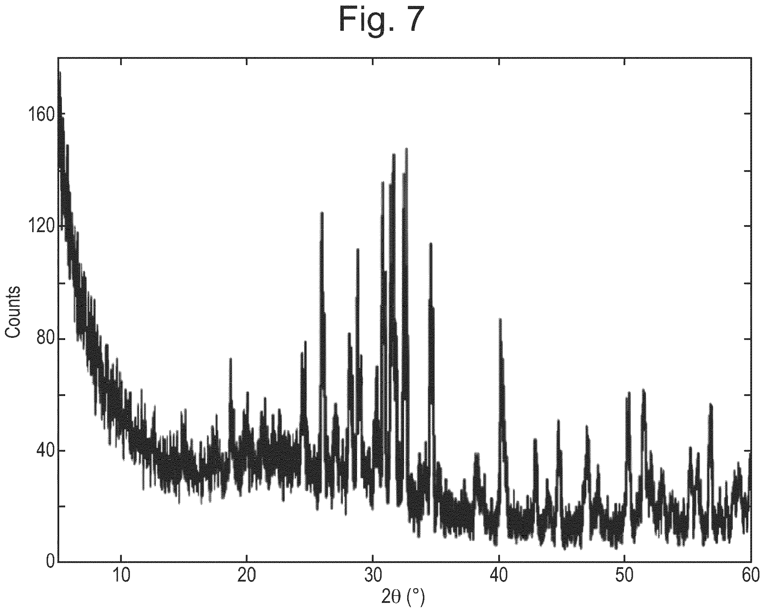

In order to perform the reaction between Ba(OH)₂, Ag₂O and periodic acid described in A.W. Sleight and R. Ward, Inorg. Chem., 1964, 3 (2), pp 292-292, we added 8 mM of Ag₂O and 16 mM of H₅IO₆ in 40 mL of formic acid and 10 mL of water. We then dissolved 160 mM of Ba(OH)₂ in 10 mL of water. We injected the Ba(OH)₂ solution into the Ag₂O and H₅IO₆ solution, and a white precipitate immediately formed inside the mixed solution. We kept the mixed solution with white precipitate in a water bath at 90°C for 12 h to form a brown powder. We washed the products with water and EtOH, and dried at 70°C for 2 hr. The products were analysed using powder X-ray diffraction (see Figure 7), and were not found to match the desired Ba₂AgIO₆ double perovskite target product.

The fact that our reproduction of the procedure described in Sleight et al. did not produce the Ba₂AgIO₆ product is consistent with the disclosure of De Hair et al [De Hair et al., Vibrational Spectra and Force Constants of Periodates with Ordered Perovskite Structure, J. inorg. Nucl. Chem, 1974, vol. 36, pp 313-315]. De Hair et al. reports the preparation of Ba₂AgIO₆ as described in Sleight et al. (see the experimental section on page 313, second column). However, De Hair reported a *yellow* colour for Ba₂AgIO₆ which is indicative of the formation of AgIO₄, not Ba₂AgIO₆ (see our synthesis of Ba₂AgIO₆ described above, the first step of which describes the production of "yellow AgIO₄ crystals"). It is also noted that the XRD cell constant given in Table 1 of De Hair et al. for Ba₂AgIO₆ is a value taken from Sleight et al. indicating that De Hair et al. did not perform any independent XRD characterisation of the material made. Therefore De Hair et al. provides no additional information, beyond that of Sleight et al., regarding the production of Ba₂AgIO₆.

### Experimental methods

For the absorption we used a Varian Cary 300 UV-Vis spectrophotometer. Steady-state PL (SSPL) and time-resolved PL (TRPL) spectra were recorded with Fluorescence Lifetime Spectrometer (Fluo Time 300, PicoQuant FmbH). The measurement was carried out excitation at 405 nm (LDH-D-C-405M), at a repetition rate of 40 MHz and 10 MHz for SSPL and TRPL, respectively. The PL signal was collected and directed toward a grating monochromator (Princeton Instruments, SP-2558), and detected with a photon-counting detector (PDM series from MPD).

### Results and discussion

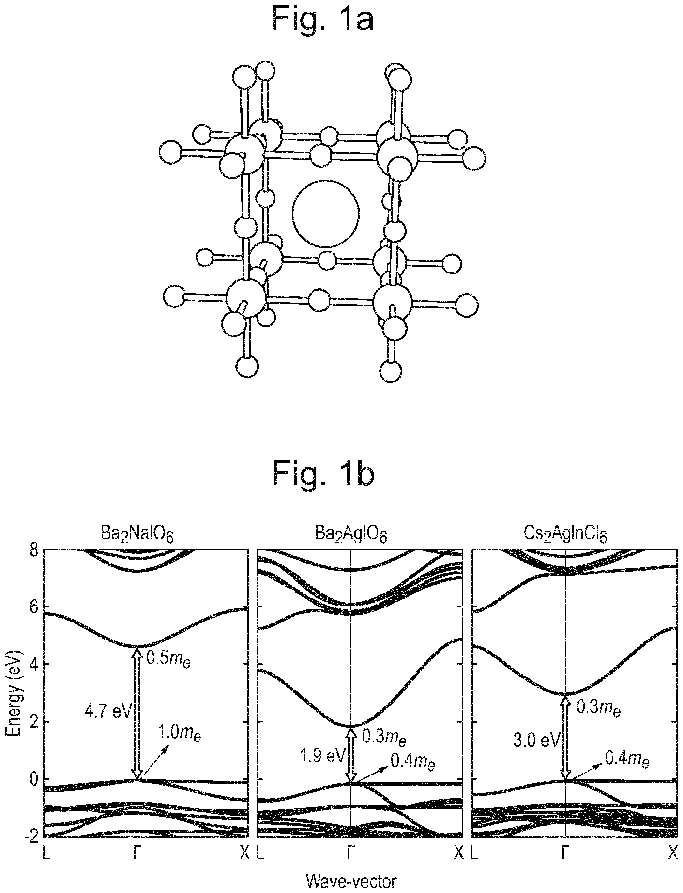

We employ density-functional theory (DFT) with the PBE functional (see Perdew, J. P.; Burke, K.; Ernzerhof, M. Phys. Rev. Lett. 1996, 77, 3865) to optimize Ba₂NaIO₆ within the F m3m space group and with Na and I arranged in a rock-salt configuration, as shown in Figure 1a. The relaxed lattice constant is 8.41°A, in good agreement with the measured value of 8.34°A (see Kubel, F.; Wandl, N.; Pantazi, M.; D'Anna, V.; Hagemann, H. Z. Anorg. Allg. Chem 2013, 639, 892-898). Next we proceed to replace Na with Ag and re-optimize the structure. The DFTPBE lattice constant of Ba₂AgIO₆ is found to be 8.56°A. We check the stability of Ba₂AgIO₆ by calculating the total energy differences for all decomposition routes into any compounds in the Materials Project database, (see Jain, A.; Ong, S. P.; Hautier, G.; Chen, W.; Richards, W. D.; Dacek, S.; Cholia, S.; Gunter, D.; Skinner, D.; Ceder, G.; Persson, K. A. APL Mater. 2013, 1, 011002) and find this double perovskite to be stable against decomposition. We investigate the electronic structure using hybrid functionals, so as to overcome the well-known band gap underestimation within DFT-PBE. In our recent work, we found that the PBE0 hybrid functional is in good agreement with the measured band gaps of similar double perovksites, therefore we also use PBE0 in the following (see Volonakis, G.; Filip, M. R.; Haghighirad, A. A.; Sakai, N.; Wenger, B.; Snaith, H. J.; Giustino, F. J. Phys. Chem. Lett. 2016, 7, 1254-1259; Volonakis, G.; Haghighirad, A. A.; Milot, R. L.; Sio, W. H.; Filip, M. R.; Wenger, B.; Johnston, M. B.; Herz, L. M.; Snaith, H. J.; Giustino, F. J. Phys. Chem. Lett. 2017, 8, 772-778; Ha, V.-A.; Waroquiers, D.; Rignanese, G.-M.; Hautier, G. Appl. Phys. Lett. 2016, 108, 201902).

Figure 1b shows the DFT-PBEO electronic band structure for the optimized Ba₂NaIO₆ and Ba₂AgIO₆. The replacement of Na^{I} with Ag^{I} leads to a considerable narrowing of the band gap, by almost 3 eV, and at the same time the bands become more dispersive. Within DFT-PBE0, the electronic band gap of Ba₂AgIO₆ is 1.9 eV, which is well within the visible range. A measure of the band dispersions near the band extrema are the electron and hole effective masses, which are indicated in Figure 1b. The electron masses are relatively low, 0.5 mₑ and 0.3mₑ for Ba₂NaIO₆ and Ba₂AgIO₆, respectively. In the case of holes, the replacement of Na by Ag reduces the effective mass from 1mₑ to 0.4mₑ. The flat band that is present for both compounds at the valence band top (vbt) is not taken into account for the calculation of the hole effective mass, although its presence is expected to hinder hole transport along the [100], [010], and [001] directions.

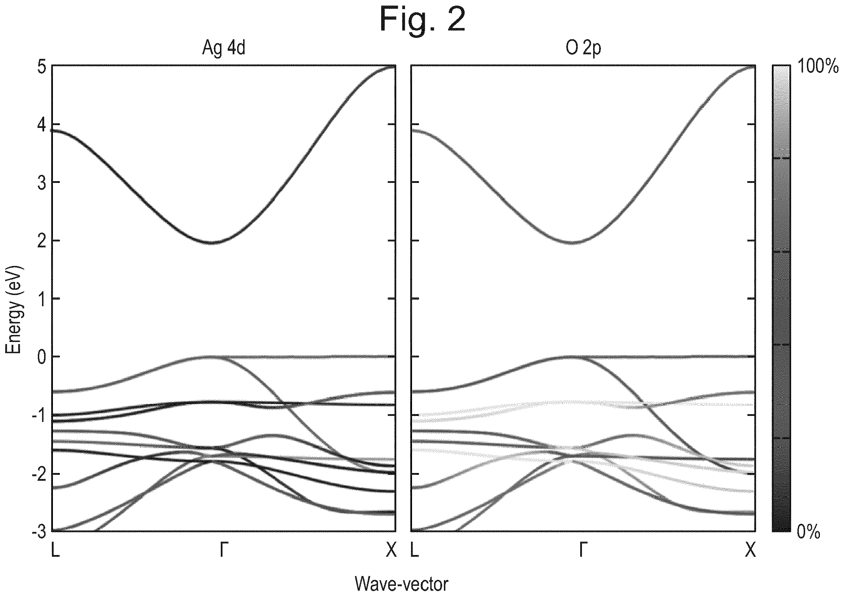

The band gap of Ba₂AgIO₆ is found to be quasi-direct in our calculations, with the vbt at X lying only 5 meV higher than the vbt at Γ, and the conduction band bottom (cbb) at Γ. Given the smallness of this difference, it is possible that more refined many-body calculations of electron-electron and electron-phonon effects will yield a direct band gap (see Onida, G.; Reining, L.; Rubio, A. Rev. Mod. Phys. 2002, 74, 601-659; Giustino, F. Rev. Mod. Phys. 2017, 89, 015003). We also find that the optical transition at Γ is forbidden, which is a feature in common with the halide double perovskites Cs₂AgInCl₆.(see Luo, J.; Li, S.; Wu, H.; Zhou, Y.; Li, Y.; Liu, J.; Li, J.; Li, K.; Yi, F.; Niu, G.; Tang, J. ACS Photonics 2018, 5, 398-405; Meng, W.; Wang, X.; Xiao, Z.; Wang, J.; Mitzi, D. B.; Yan, Y. J. Phys. Chem. Lett. 2017, 8, 2999-3007). The similarity is not limited to the nature of the optical transitions, but the entire band structures of Ba₂AgIO₆ and Cs₂AgInCl₆ are remarkably similar, as shown in Figure 1b. These similarities are no coincidence, let us see why. Ba₂AgIO₆ and Cs₂AgInCl₆ have Ag^{I}/I^{VII} and Ag^{I}/In^{III} as the cations at the B/B'-site, respectively. All these cations share the same valency: d¹⁰s⁰, with occupied 4d-states and unoccupied 5s-states. Hence in a simple ionic picture we expect 4d-states to contribute to the valence band, while the 5s-states should lie in the conduction band. In line with this expectation, the vbt of Ba₂AgIO₆ is comprised of Ag 4d-orbitals that are hybridized with O 2p-orbitals, shown in Figure 2, in the same way as the valence band of Cs₂AgInCl₆ is derived from Ag 4d-orbitals and Cl 3p-orbitals (see Volonakis, G.; Haghighirad, A. A.; Milot, R. L.; Sio, W. H.; Filip, M. R.; Wenger, B.; Johnston, M. B.; Herz, L. M.; Snaith, H. J.; Giustino, F. J. Phys. Chem. Lett. 2017, 8, 772-778). The same is true for the cbb, which contains 5s-orbitals for both compounds. Furthermore, as a consequence of the hybridization of Ag 4d_{x2-y2} orbitals with O 2-p_{x,y} orbitals at the vbt of Ba₂AgIO₆, a non-dispersive band emerges, as shown in Figure 1b. This hybridization leads to wavefunctions that are confined in two dimensions, as shown in Figure S2. We observed precisely the same feature for the case of Cs₂AgInCl₆. These strong similarities indicate that the valency of the atoms at the B/B'-sites controls the electronic structure of both compounds, even though one is a halide and one is an oxide. In the following we generalize this concept to identify halide/oxide analogs for single and double perovskites.

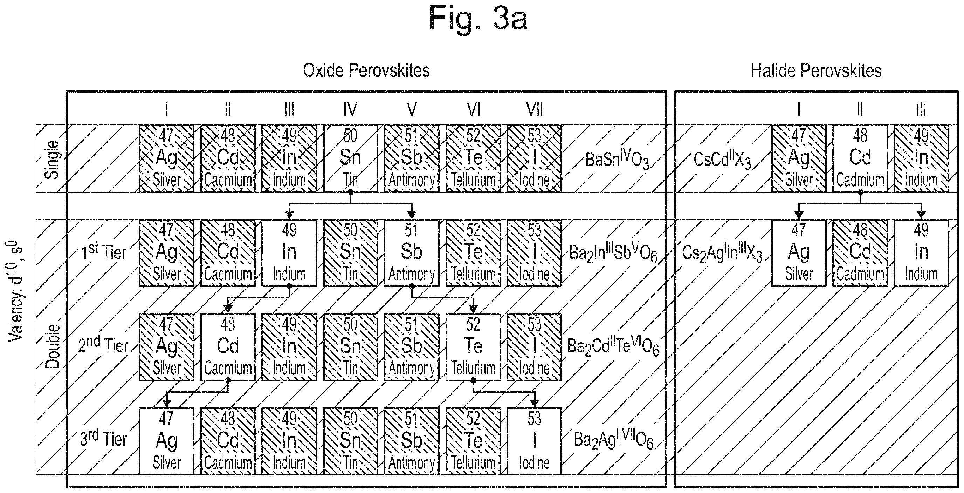

To identify all the double perovskite analogs of an AB^{IV}O₃ perovskite, we follow the splitcation approach and consider structures like A₂B^{III}B^{'V}O₆, A₂B^{II}B^{'VI}O₆, and A₂B^{I}B^{'VII}O₆. Following the illustration in Figure 3a, we will refer to these analogs as first-tier, second-tier and third-tier double perovskites, respectively. Within this framework, Ba₂InSbO₆, Ba₂CdTeO₆, and Ba₂AgIO₆ are the first-tier, second-tier, and third-tier double perovskite analogs of BaSnO₃, respectively. By design, all these compounds are isoelectronic with BaSnO₃, with their B-site cations in a d¹⁰s⁰ electronic configuration, like Sn^{IV}. Based on what we discussed above for Ba₂AgIO₆, we now employ the electronic configuration at the B-site to connect oxide with halide perovskites. For example, the analog of BaSnO₃ is CsCdCl₃, since Cd in its +2 oxidation state has the same d¹⁰s⁰ electronic configuration. Thus, their electronic band structures are expected to be similar, and this is confirmed by the calculations, see Figure 2b. For such AB^{II}X₃ halide perovskites, the +2 oxidation of the B-site cation restrict the possible halide double perovskite analogs to the first tier only. Thus, the double perovskite analogue of CsCdCl₃ is Cs₂AgInCl₆. This link, which is schematically illustrated in Figure 3a, explains why the electronic structures of Cs₂AgInCl₆ and Ba₂AgIO₆ are so similar, as we discussed in the first part of this work.

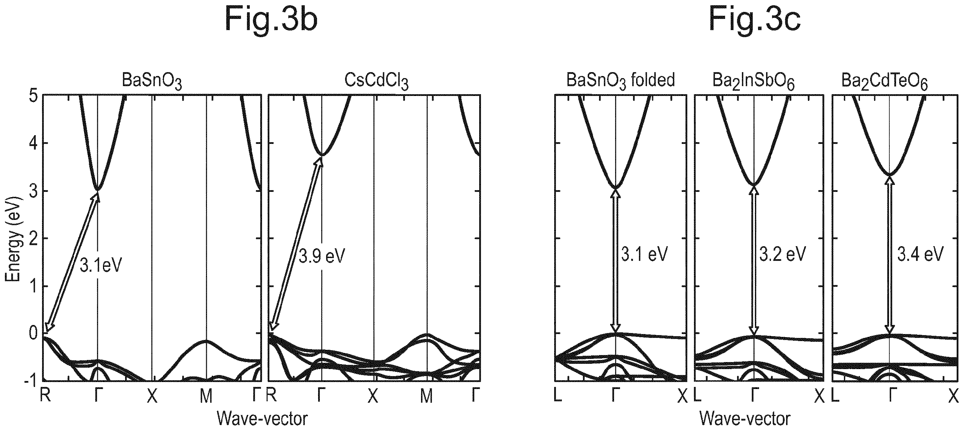

In order to meaningfully compare the electronic structure of single and double perovskites, we consider a supercell of the single perovskite ABO₃ cubic lattice, which corresponds to the fcc lattice of the double perovskite and contains two ABO₃ units. In this representation, the band structure of double perovskites is a folded version of the single perovskite bands. This band folding effect is shown in Figure 3c for the case of BaSnO₃. It is clear that the folded band structure of BaSnO₃ is very similar to the band structure of all its double perovskite analogs Ba₂InSbO₆, Ba₂CdTeO₆, Ba₂AgIO₆, as well as to that of the halide double perovskite Cs₂AgInCl₆, shown in Figures 1b and 3c. Upon folding, the indirect band gap of BaSnO₃ becomes a direct gap, but the direct transition at Γ obviously remains forbidden. This mechanism explains why the optical transition at Γ for the direct gap double perovskites Cs₂AgInCl₆ and Ba₂AgIO₆ is inherently forbidden. More generally, for perovskites with B-site cations in their d¹⁰s⁰ electronic configuration, the analogs of an indirect-gap single perovskite will always be double perovskites with a forbidden direct gap.

Given the close analogy between BaSnO₃, Ba₂AgIO₆, and Cs₂AgInCl₆, we look for all the possible analogs of the common parent compound BaSnO₃. To this aim, we use the ICSD and collect all the single and double perovskites with a d¹⁰s⁰ electronic configuration that have been synthesized so far. The halide single perovskites CsCdCl₃, CsCdBr₃, CsHgCl₃, CsCdBr₃, and CsHgI₃ have been synthesized by Wells as far back as in 1892 and 1894 (Wells, H. L. Amer. Journ. Sc. 1892, 44, 221; Wells, H. L.; Walden, P. T. Z. Anorg. Chem. 1894, 5, 266-272). Around the same time he also reported the first synthesis of lead halide perovskites CsPbX₃ (X = CI,Br,I - Wells, H. L. Z. Anorg. Chem. 1893, 3, 195-210). The double perovskites Ba₂CdTeO₆ and Ba₂InSbO₆ have been synthesized and studied as possible transparent conducting oxides, and their band gaps were reported within the same range as the band gap of BaSnO₃ (Vasala, S.; Karppinen, M. Prog. Solid State Chem. 2015, 43, 1-36; Sleight, A. W.; Ward, R. Inorg. Chem. 1964, 3, 292-292).

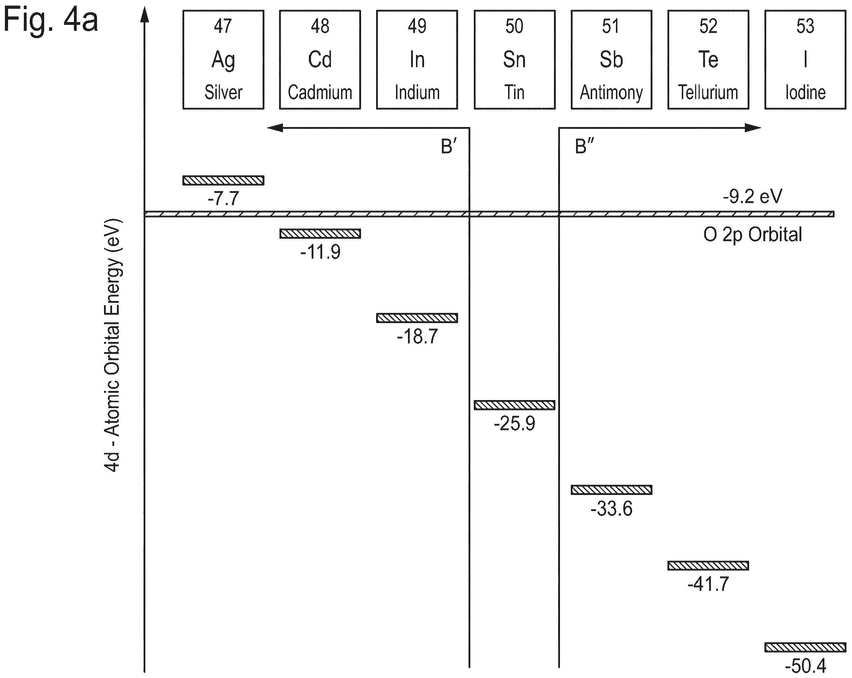

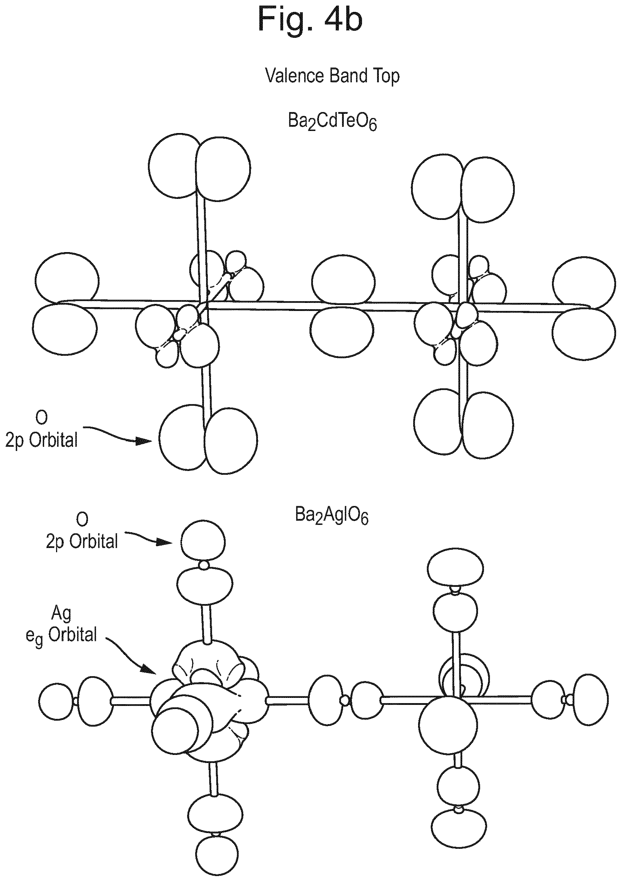

As shown in Figures 3b and 3c, DFT-PBEO calculations for the BaSnO₃ analogs, Ba₂CdTeO₃, Ba₂InSb₃, and BaSnO₃, using the experimental lattice parameters, yield large gaps of 3.4 eV, 3.2 eV and 3.1 eV, respectively, as in the experiments, and yield similar band structures for all compounds. However, when we compare to Ba₂AgIO₆ in Fig. 1b, we see that in this case the gap, 1.9 eV, is considerably smaller than in all other cases. This anomalous and intriguing feature of Ba₂AgIO₆ can be explained as follows. In BaSnO₃, the conduction band bottom is formed by antibonding s-s^{∗} orbitals of Sn-5s and O-2s, and the valence band top is comprised of non-bonding O-2p orbitals. When we replace two Sn^{IV} atoms with combinations of either In^{III}/Sb^{V}, Cd^{II}/Te^{VI}, or Ag^{I}/I^{VII} in a double perovskites lattice, the atomic energy levels of the occupied 4d orbitals change as shown in Figure 4a. In all double perovskites except Ba₂AgIO₆, the O-2p energy is above the energy of the d states, therefore the character of the vbt is non-bonding O-2p orbitals, like BaSnO₃. When we reach Ag, the energy of the 4d orbitals happens to cross the O-2p level, hence the vbt of Ba₂AgIO₆ is formed by hybridized Ag-4d and O-2p states. This transition is manifest in the electronic wavefunctions at the vbt, which are shown in Figure 4b. Here we can see that in Ba₂CdTeO₆ only non-bonding O-2p orbitals are at the vbt, while for Ba₂AgIO₆ the vbt also contains Ag 4d-orbitals. This is a unique property of Ba₂AgIO₆ which has the effect of reducing the band gap and making the bands more dispersive, and which makes this compound stand out among all the d¹⁰s⁰ oxide perovskites.

### Synthesis and characterization of Ba₂AgIO₆

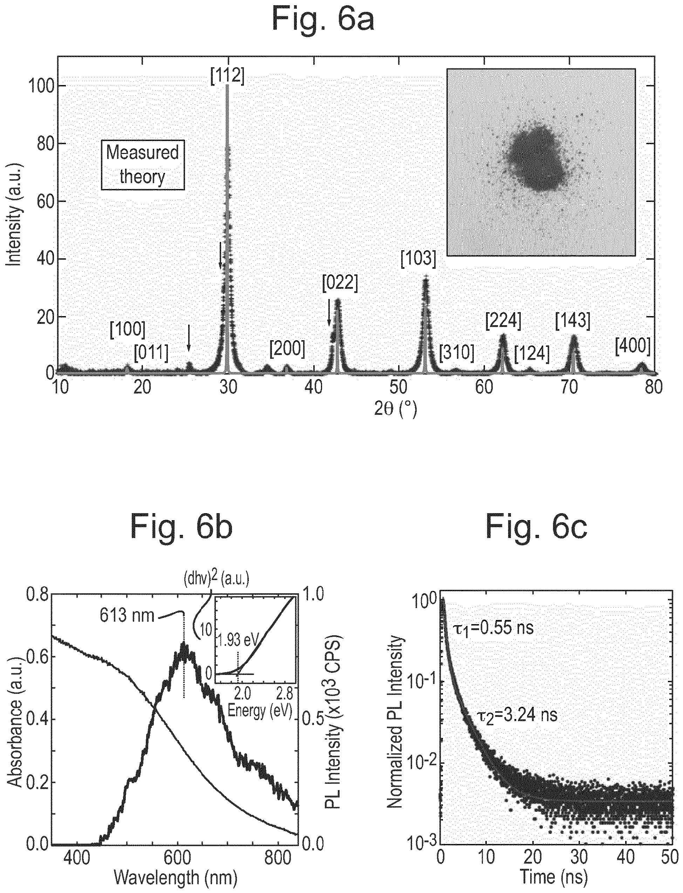

Having established that Ba₂AgIO₆ has a band structure that resembles Cs₂AgInCl₆ and a band gap well within the visible range, we proceed with the experimental synthesis and characterization. To this aim, we followed a novel two-step solution process to first form yellow AgIO₄ crystals (see Fig 5), and subsequently form Ba₂AgIO₆ as detailed in the Supporting Information. The inset of Figure 6a shows the resulting brown powder. In order to characterize the structure we measured its X-ray diffraction (XRD) pattern, as shown in Figure 6a. We could match the XRD data to a double perovskite lattice with a lattice constant of 8.45°A, which is in good agreement with our DFT-PBE predicted value of 8.56°A Furthermore, when we compare the XRD pattern simulated with the DFTPBE structure, we obtain very good agreement with the experimental data, see red line in Figure 6a. This confirms that we formed the double perovskite Ba₂AgIO₆. We note that this is rare occurrence where an oxide perovskite is formed through a low-temperature solution process. In Figure 6b we show the optical absorption and photoluminescence (PL) measurements of the synthesized Ba₂AgIO₆ powder. Using a Tauc plot we estimate an optical band gap of 1.93 eV. This value matches nicely our predicted PBE0 gap of 1.9 eV. We also observe a broad photoluminescence signal, which is centered at 613 nm and matches the absorption onset. The PL broadening is likely related to the presence of defects and/or poor crystallinity, but the location of the PL peak appears to suggest emission via band-to-band recombination, since it coincides with the direct band gap energy. Finally, in Figure 6c we show time-resolved PL data. A double exponential fit yields a fast timescale of 0.55 ns and a slower timescale of 3.24 ns. These values are slightly faster than those determined for halide double perovskites such as Cs₂BiAgCl₆, Cs₂BiAgBr₆, and Cs₂AgInCl₆ ( Volonakis, G.; Filip, M. R.; Haghighirad, A. A.; Sakai, N.; Wenger, B.; Snaith, H. J.; Giustino, F. J. Phys. Chem. Lett. 2016, 7, 1254-1259; Volonakis, G.; Haghighirad, A. A.; Milot, R. L.; Sio, W. H.; Filip, M. R.; Wenger, B.; Johnston, M. B.; Herz, L. M.; Snaith, H. J.; Giustino, F. J. Phys. Chem. Lett. 2017, 8, 772-778; Filip, M. R.; Hillman, S.; Haghighirad, A. A.; Snaith, H. J.; Giustino, F. J. Phys. Chem. Lett. 2016, 7, 2579-2585; Steele, J. A. et al. Adv. Mater. 2018, 30, 1804450). We note that such relatively narrow band gap and the low effective masses make Ba₂AgIO₆ stand out among oxide perovskites, which typically exhibit wide band gaps and heavy effective masses.

### Conclusions

In summary, in this work we have established the links between oxide and halide single and double perovskites. The key to identify halide/oxide analogs is the valency of the B-site cations, which controls the electronic structure of these compounds. Using this new concept, we demonstrated that the previously reported halide double perovskite Cs₂AgInCl₆ is the analog of BaSnO₃, and we identified for the first time the oxide double perovskite Ba₂AgIO₆ as a semiconductor with a band gap in the visible. We reported a novel synthesis route of Ba₂AgIO₆ via solution, and reported the characterisation of its crystallographic and optical properties for the first time. We found a gap around 1.9 eV and a broad photoluminescence signal at the same energy, in agreement with our calculations. We believe that the new semiconductor Ba₂AgIO₆ is a promising candidate for optoelectronic applications, such as mixed oxide/halide perovskite solar-cells, novel oxide-based light emitting devices, and photocatalysis. Tunability of the electronic and optical properties of this compound could be achieved via cation and anion substitution.

## Claims

1. An optoelectronic material comprising a compound, wherein the compound comprises:
(i) one or more cations, A;
(ii) one or more first B cations, Bⁿ⁺, at least one of which is Ag⁺;
(iii) one or more second B cations, B^{m+}, at least one of which is a heptacation, B⁷⁺; and
(iv) one or more chalcogen anions, X;
wherein the one or more first B cations, Bⁿ⁺ are different from the one or more second B cations, B^{m+}; n represents the oxidation state of the first B cation and is a positive integer of from 1 to 7 inclusive; m represents the oxidation state of the second B cation and is a positive integer of from 1 to 7 inclusive; and n + m is equal to 8.

2. An optoelectronic material according to claim 1, wherein the optoelectronic material is a photovoltaic material or an electroluminescent material.

3. An optoelectronic material according to claim 1 or claim 2, wherein at least one of the one or more first cations, Bⁿ⁺, and at least one of the one or more second cations, B^{m+}, have the electronic configuration Nd¹⁰(N+1)s⁰ wherein N is an integer from 3 to 5.

4. An optoelectronic material according to any preceding claim, wherein n is 1 or 2 and m is 6 or 7,
optionally wherein n is 1 and m is 7.

5. An optoelectronic material according to any preceding claim, wherein
(a) the one or more first cations, Bⁿ⁺, additionally comprise one or more of Li⁺, Na⁺, K⁺, Rb⁺, Cs⁺, Cu⁺, Au⁺ and Hg⁺; and/or
(b) the one or more second cations, B^{m+}, comprise one or more halogen cations in the +7 oxidation state; and/or
(c) the one or more first cations, Bⁿ⁺, comprise Ag⁺ and the one or more second cations, B^{m+}, comprise I⁷⁺.

6. An optoelectronic material according to any preceding claim, wherein the one or more chalcogen anions, X, comprise O²⁻, S²⁻, Se²⁻ or Te²⁻,
preferably wherein the one or more chalcogen anions, X, comprise O²⁻ or S²⁻.

7. An optoelectronic material according to any one of claims 1 to 6, wherein the compound is Sr₂AgIO₆ or Ba₂AgIO₆, preferably wherein the compound is Ba₂AgIO₆.

8. A compound comprising:
(i) One or more cations, A;
(ii) One or more monocations, B⁺, wherein one of said one or more monocations is Ag⁺;
(iii) One or more heptacations, B⁷⁺; and
(iv) One or more chalcogen anions, X.

9. A compound according to claim 8, wherein one of said one or more heptacations, B⁷⁺, is a halogen heptacation,
preferably wherein one of said one or more heptacations, B⁷⁺, is I⁷⁺.

10. A compound according to claim 8 or claim 9, wherein the compound is Sr₂AgIO₆ or Ba₂AgIO₆, typically Ba₂AgIO₆.

11. A photocatalyst material comprising a compound, wherein the compound comprises:
(i) one or more cations, A;
(ii) one or more first B cations, Bⁿ⁺, at least one of which is Ag⁺;
(iii) one or more second B cations, B^{m+}, at least one of which is a heptacation, B⁷⁺; and
(iv) one or more chalcogen anions, X;
wherein the one or more first B cations, Bⁿ⁺ are different from the one or more second B cations, B^{m+}; n represents the oxidation state of the first B cation and is 1 or 2; m represents the oxidation state of the second B cation and is 6 or 7; and n + m is equal to 8.

12. A semiconductor device comprising an semiconducting material, wherein the semiconducting material comprises a compound comprising:
(i) one or more cations, A;
(ii) one or more first B cations, Bⁿ⁺, at least one of which is Ag⁺;
(iii) one or more second B cations, B^{m+}, at least one of which is a heptacation, B⁷⁺; and
(iv) one or more chalcogen anions, X;
wherein the one or more first B cations, Bⁿ⁺ are different from the one or more second B cations, B^{m+}; n represents the oxidation state of the first B cation and is a positive integer of from 1 to 7 inclusive; m represents the oxidation state of the second B cation and is a positive integer of from 1 to 7 inclusive; and n + m = 8.

13. A process for producing a compound comprising
(i) one or more cations, A;
(ii) one or more first B cations, Bⁿ⁺, at least one of which is Ag⁺;
(iii) one or more second B cations, B^{m+}, at least one of which is a heptacation, B⁷⁺; and
(iv) one or more chalcogen anions, X;
wherein the one or more first B cations, Bⁿ⁺ are different from the one or more second B cations, B^{m+}; n represents the oxidation state of the first B cation and is a positive integer of from 1 to 7 inclusive; m represents the oxidation state of the second B cation and is a positive integer of from 1 to 7 inclusive; and n + m = 8;
said process comprising treating a precursor compound comprising the one or more first B cations, Bⁿ⁺ , and the one or more second B cations, B^{m+}, with a composition comprising the one or more cations, A to obtain the compound,
wherein the precursor compound is a solid, which process comprises dissolving the solid precursor compound comprising the one or more first B cations, Bⁿ⁺ , and the one or more second B cations, B^{m+}, in a solvent to obtain a solution comprising the one or more first B cations Bⁿ⁺ , and the one or more second B cations, B^{m+}, and contacting the solution with the composition comprising the one or more cations, A, to obtain the compound.

14. An electronic material comprising a compound, wherein the compound is as defined in any one of claims 1 to 10.

## Patentansprüche

1. Optoelektronisches Material, umfassend eine Verbindung, wobei die Verbindung umfasst:
(i) ein oder mehrere Kationen, A;
(ii) ein oder mehrere erste B-Kationen, Bⁿ⁺, von denen wenigstens eines Ag⁺ ist;
(iii) ein oder mehrere zweite B-Kationen, B^{m+}, von denen wenigstens eines ein Heptakation, B⁷⁺, ist; und
(iv) ein oder mehrere Chalkogenanionen, X;
wobei das eine oder die mehreren ersten B-Kationen, Bⁿ⁺, sich von dem einen oder den mehreren zweiten B-Kationen B^{m+} unterscheiden; n den Oxidierungszustand des ersten B-Kations darstellt und eine positive ganze Zahl von 1 bis einschließlich 7 ist; m den Oxidierungszustand des zweiten B-Kations darstellt und eine positive ganze Zahl von 1 bis einschließlich 7 ist; und n+m 8 entspricht.

2. Optoelektronisches Material nach Anspruch 1, wobei das optoelektronische Material ein Photovoltaikmaterial oder ein Elektrolumineszenzmaterial ist.

3. Optoelektronisches Material nach Anspruch 1 oder 2, wobei wenigstens eines des einen oder der mehreren ersten Kationen, Bⁿ⁺, und wenigstens eines des einen oder der mehreren zweiten Kationen B^{m+} die elektronische Konfiguration Nd¹⁰(N+1)s⁰ aufweisen, wobei N eine ganze Zahl von 3 bis 5 ist.

4. Optoelektronisches Material nach einem vorhergehenden Anspruch, wobei n 1 oder 2 ist und m 6 oder 7 ist,
optional wobei n 1 ist und m 7 ist.

5. Optoelektronisches Material nach einem vorhergehenden Anspruch, wobei
(a) das eine oder die mehreren ersten Kationen, Bⁿ⁺, zusätzlich ein oder mehrere von Li⁺, Na⁺, K⁺, Rb⁺, Cs⁺, Cu⁺, Au⁺ und Hg⁺ umfassen; und/oder
(b) das eine oder die mehreren zweiten Kationen, B^{m+}, ein oder mehrere Halogenkationen in dem +7-Oxidierungszustand umfassten; und/oder
(c) das eine oder die mehreren ersten Kationen, Bⁿ⁺, Ag⁺ umfassen und das eine oder die mehreren zweiten Kationen, B^{m+}, I⁷⁺ umfassen.

6. Optoelektronisches Material nach einem vorhergehenden Anspruch, wobei das eine oder die mehreren Chalkogenanionen, X, O²⁻, S²⁻, Se²⁻ oder Te²⁻ umfassen,
vorzugsweise wobei das eine oder die mehreren Chalkogenanionen, X, O²⁻ oder S²⁻umfassen.

7. Optoelektronisches Material nach einem der Ansprüche 1 bis 6, wobei die Verbindung Sr₂AgIO₆ oder Ba₂AgIO₆ ist, vorzugsweise wobei die Verbindung Ba₂AgIO₆ ist.

8. Verbindung, umfassend:
(i) ein oder mehrere Kationen, A;
(ii) ein oder mehrere Monokationen, B⁺, wobei eines des einen oder der mehreren Monokationen Ag⁺ ist;
(iii) ein oder mehrere Heptakationen, B⁷⁺; und
(iv) ein oder mehrere Chalkogenanionen, X.

9. Verbindung nach Anspruch 8, wobei eines des einen oder der mehreren Heptakationen, B⁷⁺, ein Halogenheptakation ist,
vorzugsweise wobei eines des einen oder mehreren Heptakationen, B⁷⁺, I⁷⁺ ist.

10. Verbindung nach Anspruch 8 oder 9, wobei die Verbindung Sr₂AgIO₆ oder Ba₂AgIO₆ in der Regel Ba₂AgIO₆ ist.

11. Photokatalysatormaterial, umfassend eine Verbindung, wobei die Verbindung umfasst:
(i) ein oder mehrere Kationen, A;
(ii) ein oder mehrere erste B-Kationen, Bⁿ⁺, von denen wenigstens eines Ag⁺ ist;
(iii) ein oder mehrere zweite B-Kationen, B^{m+}, von denen wenigstens eines ein Heptakation, B⁷⁺, ist; und
(iv) ein oder mehrere Chalkogenanionen, X;
wobei das eine oder die mehreren ersten B-Kationen, Bⁿ⁺, sich von dem einen oder den mehreren zweiten B-Kationen B^{m+} unterscheiden; n den Oxidierungszustand des ersten B-Kations darstellt und 1 oder 2 ist; m den Oxidierungszustand des zweiten B-Kations darstellt und 6 oder 7 ist; und n+m 8 entspricht.

12. Halbleitervorrichtung, umfassend ein halbleitendes Material, wobei das halbleitende Material eine Verbindung umfasst, umfassend:
(i) ein oder mehrere Kationen, A;
(ii) ein oder mehrere erste B-Kationen, Bⁿ⁺, von denen wenigstens eines Ag⁺ ist;
(iii) ein oder mehrere zweite B-Kationen, B^{m+}, von denen wenigstens eines ein Heptakation, B⁷⁺, ist; und
(iv) ein oder mehrere Chalkogenanionen, X;
wobei das eine oder die mehreren ersten B-Kationen, Bⁿ⁺, sich von dem einen oder den mehreren zweiten B-Kationen B^{m+} unterscheiden; n den Oxidierungszustand des ersten B-Kations darstellt und eine positive ganze Zahl von 1 bis einschließlich 7 ist; m den Oxidierungszustand des zweiten B-Kations darstellt und eine positive ganze Zahl von 1 bis einschließlich 7 ist; und n+m 8 entspricht.

13. Verfahren zum Herstellen einer Verbindung, umfassend:
(i) ein oder mehrere Kationen, A;
(ii) ein oder mehrere erste B-Kationen, Bⁿ⁺, von denen wenigstens eines Ag⁺ ist;
(iii) ein oder mehrere zweite B-Kationen, B^{m+}, von denen wenigstens eines ein Heptakation, B⁷⁺, ist; und
(iv) ein oder mehrere Chalkogenanionen, X;
wobei das eine oder die mehreren ersten B-Kationen, Bⁿ⁺, sich von dem einen oder den mehreren zweiten B-Kationen B^{m+} unterscheiden; n den Oxidierungszustand des ersten B-Kations darstellt und eine positive ganze Zahl von 1 bis einschließlich 7 ist; m den Oxidierungszustand des zweiten B-Kations darstellt und eine positive ganze Zahl von 1 bis einschließlich 7 ist; und n+m 8 entspricht;
das Verfahren das Behandeln einer Vorläuferverbindung, umfassend das eine oder die mehreren ersten B-Kationen, Bⁿ⁺, und das eine oder die mehreren zweiten B-Kationen, B^{m+}, mit einer Zusammensetzung umfasst, die das eine oder die mehreren Kationen A umfasst, um die Verbindung zu erhalten,
wobei die Vorläuferverbindung ein Feststoff ist, wobei das Verfahren das Auflösen der festen Vorläuferverbindung, umfassend das eine oder die mehreren ersten B-Kationen, Bⁿ⁺, und das eine oder die mehreren zweiten B-Kationen, B^{m+}, in einem Lösungsmittel, um eine Lösung zu erhalten, die das eine oder die mehreren ersten B-Kationen, Bⁿ⁺, und das eine oder die mehreren zweiten B-Kationen, B^{m+}, umfasst, und das Inberührungbringen der Lösung mit der Zusammensetzung umfasst, die das eine oder die mehreren Kationen A umfasst, um die Verbindung zu erhalten.

14. Elektronisches Material, umfassend eine Verbindung, wobei die Verbindung wie in einem der Ansprüche 1 bis 10 definiert ist.

## Revendications

1. Matériau optoélectronique comprenant un composé, dans lequel le composé comprend :
(i) un ou plusieurs cations, A ;
(ii) un ou plusieurs premiers cations B, Bⁿ⁺, dont au moins un est Ag⁺ ;
(iii) un ou plusieurs deuxièmes cations B, B^{m+}, dont au moins un est un heptacation, B⁷⁺ ; et
(iv) un ou plusieurs anions chalcogènes, X ;
dans lequel l'un ou plusieurs premiers cations B, Bⁿ⁺, sont différents de l'un ou plusieurs deuxièmes cations B, B^{m+} ; n représente l'état d'oxydation du premier cation B et est un entier positif de 1 à 7 inclus ; m représente l'état d'oxydation du deuxième cation B et est un entier positif de 1 à 7 inclus ; et n + m est égal à 8.

2. Matériau optoélectronique selon la revendication 1, dans lequel le matériau optoélectronique est un matériau photovoltaïque ou un matériau électroluminescent.

3. Matériau optoélectronique selon la revendication 1 ou la revendication 2, dans lequel au moins un de l'un ou plusieurs premiers cations, Bⁿ⁺, et au moins un de l'un ou plusieurs deuxièmes cations, B^{m+}, ont la configuration électronique Nd¹⁰(N+1)s⁰ dans lequel N est un entier de 3 à 5.

4. Matériau optoélectronique selon l'une quelconque des revendications précédentes, dans lequel n vaut 1 ou 2 et m vaut 6 ou 7,
éventuellement dans lequel n vaut 1 et m vaut 7.

5. Matériau optoélectronique selon l'une quelconque des revendications précédentes, dans lequel
(a) l'un ou plusieurs premiers cations, Bⁿ⁺, comprennent en outre un ou plusieurs parmi Li⁺, Na⁺, K⁺, Rb⁺, Cs⁺, Cu⁺, Au⁺ et Hg⁺ ; et/ou
(b) l'un ou plusieurs deuxièmes cations, B^{m+}, comprennent un ou plusieurs cations halogène à l'état d'oxydation +7 ; et/ou
(c) l'un ou plusieurs premiers cations, Bⁿ⁺, comprennent Ag⁺ et l'un ou plusieurs deuxièmes cations, B^{m+}, comprennent I⁷⁺.

6. Matériau optoélectronique selon l'une quelconque des revendications précédentes, dans lequel l'un ou plusieurs anions chalcogènes, X, comprennent O²⁻, S²⁻, Se²⁻ ou Te²⁻,
de préférence dans lequel l'un ou plusieurs anions chalcogènes, X, comprennent O²⁻ ou S²⁻.

7. Matériau optoélectronique selon l'une quelconque des revendications 1 à 6, dans lequel le composé est Sr₂AgIO₆ ou Ba₂AgIO₆, de préférence dans lequel le composé est Ba₂AgIO₆.

8. Composé comprenant :
(i) un ou plusieurs cations, A ;
(ii) un ou plusieurs monocations, B⁺, dans lequel l'un desdits un ou plusieurs monocations est Ag⁺ ;
(iii) un ou plusieurs heptacations, B⁷⁺ ; et
(iv) un ou plusieurs anions chalcogènes, X.

9. Composé selon la revendication 8, dans lequel l'un desdits un ou plusieurs heptacations, B⁷⁺, est un heptacation halogène,
de préférence dans lequel l'un desdits un ou plusieurs heptacations, B⁷⁺, est I⁷⁺.

10. Composé selon la revendication 8 ou la revendication 9, dans lequel le composé est Sr₂AgIO₆ ou Ba₂AgIO₆, typiquement Ba₂AgIO₆.

11. Matériau photocatalyseur comprenant un composé, dans lequel le composé comprend :
(i) un ou plusieurs cations, A ;
(ii) un ou plusieurs premiers cations B, Bⁿ⁺, dont au moins un est Ag⁺ ;
(iii) un ou plusieurs deuxièmes cations B, B^{m+}, dont au moins un est un heptacation, B⁷⁺ ; et
(iv) un ou plusieurs anions chalcogènes, X ;
dans lequel l'un ou plusieurs premiers cations B, Bⁿ⁺, sont différents de l'un ou plusieurs deuxièmes cations B, B^{m+} ; n représente l'état d'oxydation du premier cation B et vaut 1 ou 2 ; m représente l'état d'oxydation du deuxième cation B et vaut 6 ou 7 ; et n + m est égal à 8.

12. Dispositif semi-conducteur comprenant un matériau semi-conducteur, dans lequel le matériau semi-conducteur comprend un composé comprenant :
(i) un ou plusieurs cations, A ;
(ii) un ou plusieurs premiers cations B, Bⁿ⁺, dont au moins un est Ag⁺ ;
(iii) un ou plusieurs deuxièmes cations B, B^{m+}, dont au moins un est un heptacation, B⁷⁺ ; et
(iv) un ou plusieurs anions chalcogènes, X ;
dans lequel l'un ou plusieurs premiers cations B, Bⁿ⁺, sont différents de l'un ou plusieurs deuxièmes cations B, B^{m+} ; n représente l'état d'oxydation du premier cation B et est un entier positif de 1 à 7 inclus ; m représente l'état d'oxydation du deuxième cation B et est un entier positif de 1 à 7 inclus ; et n + m = 8.

13. Procédé de production d'un composé comprenant
(i) un ou plusieurs cations, A ;
(ii) un ou plusieurs premiers cations B, Bⁿ⁺, dont au moins un est Ag⁺ ;
(iii) un ou plusieurs deuxièmes cations B, B^{m+}, dont au moins un est un heptacation, B⁷⁺ ; et
(iv) un ou plusieurs anions chalcogènes, X ;
dans lequel l'un ou plusieurs premiers cations B, Bⁿ⁺, sont différents de l'un ou plusieurs deuxièmes cations B, B^{m+} ; n représente l'état d'oxydation du premier cation B et est un entier positif de 1 à 7 inclus ; m représente l'état d'oxydation du deuxième cation B et est un entier positif de 1 à 7 inclus ; et n + m = 8 ;
ledit procédé comprenant le traitement d'un composé précurseur comprenant l'un ou plusieurs premiers cations B, Bⁿ⁺, et l'un ou plusieurs deuxièmes cations B, B^{m+}, avec une composition comprenant l'un ou plusieurs cations, A pour obtenir le composé,
dans lequel le composé précurseur est un solide, lequel procédé comprend la dissolution du composé précurseur solide comprenant l'un ou plusieurs premiers cations B, Bⁿ⁺, et l'un ou plusieurs deuxièmes cations B, B^{m+}, dans un solvant pour obtenir une solution comprenant l'un ou plusieurs premiers cations B, Bⁿ⁺, et l'un ou plusieurs deuxièmes cations B, B^{m+}, et la mise en contact de la solution avec la composition comprenant l'un ou plusieurs cations, A, pour obtenir le composé.

14. Matériau électronique comprenant un composé, dans lequel le composé est tel que défini dans l'une quelconque des revendications 1 à 10.
